# EUROPEAN PATENT APPLICATION

(11) **EP 4 832 714 A1**
(43) Date of publication of application: **28.10.2026**
(21) Application number: 24953515.4
(22) Date of filing: 24.09.2024
(51) Int. Cl.: H10K 59/121, H10K 59/30, G09G 3/32, G09G 3/3225

(54) **DISPLAY PANEL AND DISPLAY DEVICE**

(30) Priority: 06.09.2024 CN 202411253211
(71) Applicant: Wuhan Tianma Microelectronics Co., Ltd., Wuhan, Hubei 430205 (CN); Xiamen Tianma Display Technology Co., Ltd., Xiamen, Fujian 361101 (CN)
(72) Inventor: DAI, Hao, Wuhan, Hubei 430205 (CN); ZHANG, Dian, Wuhan, Hubei 430205 (CN); MA, Yangzhao, Wuhan, Hubei 430205 (CN); DUN, Dongliang, Wuhan, Hubei 430205 (CN)
(74) Representative: Völkl Siebenson Patentanwälte - Partnerschaft mbB
(86) International application number: PCT/CN2024/120688
(87) International publication number: WO 2026/051129

(57) **Abstract**

Disclosed in the present invention are a display panel and a display device. The display panel comprises: first-color light-emitting elements and a second-color light-emitting elements; a plurality of first light-emitting element rows and a plurality of first light-emitting element columns, wherein each first light-emitting element row comprises first-color light-emitting elements and second-color light-emitting elements alternately arranged in a first direction, and each first light-emitting element column comprises first-color light-emitting elements and second-color light-emitting elements alternately arranged in a second direction; and a plurality of first pixel circuits, wherein a plurality of first pixel circuits in a first pixel circuit row are electrically connected to a plurality of light-emitting elements in the same first light-emitting element row; and among two adjacent first pixel circuit columns, the first pixel circuits in one first pixel circuit column are electrically connected to the first-color light-emitting elements in at least one first light-emitting element column, and the first pixel circuits in the other first pixel circuit column are electrically connected to the second-color light-emitting elements in the at least one first light-emitting element column. The present invention can reduce the power consumption of the display panel.

## Description

### CROSS-REFERENCE TO RELATED APPLICATIONS

The present application claims the priority to Chinese Patent Application No. 202411253211.6 filed on September 6, 2024, and titled "DISPLAY PANEL AND DISPLAY DEVICE", which is incorporated herein by reference in its entirety.

### TECHNICAL FIELD

The present application relates to the technical field of display, and particularly to a display panel and a display device.

### BACKGROUND

With continuous development of display technologies, display panels have been widely used in people's production and life. Thus, users have a growing demand for longer battery life of display devices. Therefore, a technical problem that urgently needs to be solved is how to improve the battery life of display devices.

However, there is a problem of excessive power consumption in the display panels in the prior art, which affects the battery life of the display devices.

### SUMMARY

The present application provides a display panel and a display device to reduce the power consumption of the display panel.

In one aspect, the present application provides a display panel, and the display panel comprises a plurality of light-emitting elements, the plurality of light-emitting elements comprising at least first-color light-emitting elements and second-color light-emitting elements, color emitted by the first-color light-emitting elements is different from color emitted by the second-color light-emitting elements; the plurality of light-emitting elements comprising a plurality of first light-emitting element columns arranged along a first direction and a plurality of first light-emitting element rows arranged along a second direction, each first light-emitting element row comprising the first-color light-emitting elements and the second-color light-emitting elements alternately arranged along the first direction, each first light-emitting element column comprising the first-color light-emitting elements and the second-color light-emitting elements alternately arranged along the second direction, the first direction not parallel to the second direction; and a plurality of first pixel circuits, the plurality of first pixel circuits comprising a plurality of first pixel circuit rows arranged along the second direction and a plurality of first pixel circuit columns arranged along the first direction, each first pixel circuit rows comprising a plurality of first pixel circuits arranged along the first direction, and each first pixel circuit columns comprising a plurality of first pixel circuits arranged along the second direction. The light-emitting elements that are electrically connected to the first pixel circuits, respectively, in one of the first pixel circuit rows are in a same one of the first light-emitting element rows. For two adjacent first pixel circuit columns, each first pixel circuit in one of the two first pixel circuit columns is electrically connected to a respective first-color light-emitting element in a first group of first light-emitting element columns among the plurality of first light-emitting element columns, and each first pixel circuit in another first pixel circuit column is electrically connected to a respective second-color light-emitting element in a second group of first light-emitting element columns among the plurality of first light-emitting element columns.

In the other aspect, the present application provides a display device which comprises the above-described display panel.

In the present application, the first light-emitting element columns each comprise the first-color light-emitting elements and the second-color light-emitting elements alternately arranged along the second direction, and the first pixel circuit columns each comprise the plurality of first pixel circuits arranged along the second direction. By optimizing the connection relationship between the light-emitting elements and the first pixel circuits, it enables that for two adjacent first pixel circuit columns, the first pixel circuits of one first pixel circuit column are electrically connected to the first-color light-emitting elements of at least one first light-emitting element column, and the first pixel circuits of the other first pixel circuit column are electrically connected to the second-color light-emitting elements of at least one first light-emitting element column. In the present application, a plurality of first pixel circuits of one first pixel circuit column drive a plurality of light-emitting elements with the same color, and thus a data line electrically connected to one pixel circuit column independently drives a plurality of light-emitting elements with the same light-emitting color. Therefore, there is no scenario that a plurality of light-emitting elements with different light-emitting colors share one data line. Under this condition, the data signals provided by the data line to light-emitting elements of different rows will not experience voltage jumps, which reduces a load on the data line, and thus reduces the power consumption of the display panel.

### BRIEF DESCRIPTION OF THE DRAWINGS

Fig. 1 shows a schematic view of a display panel provided in some embodiments of the present application;
Fig. 2 shows a schematic view of another display panel provided in some embodiments of the present application;
Fig. 3 shows a schematic structural view of the display panel shown in Fig. 2;
Fig. 4 shows a schematic view of a first pixel circuit provided in some embodiments of the present application;
Fig. 5 shows a schematic view of yet another display panel provided in some embodiments of the present application;
Fig. 6 shows a schematic view of yet another display panel provided in some embodiments of the present application;
Fig. 7 shows a schematic structural view of the display panel shown in Fig. 6;
Fig. 8 shows a schematic view of yet another display panel provided in some embodiments of the present application;
Fig. 9 shows a schematic view of yet another display panel provided in some embodiments of the present application;
Fig. 10 shows a schematic structural view of the display panel shown in Fig. 9;
Fig. 11 shows a schematic view of yet another display panel provided in some embodiments of the present application;
Fig. 12 shows a schematic structural view of the display panel shown in Fig. 11;
Fig. 13 shows a schematic view of yet another display panel provided in some embodiments of the present application;
Fig. 14 shows a schematic view of yet another display panel provided in some embodiments of the present application;
Fig. 15 shows a schematic structural view of the display panel shown in Fig. 14;
Fig. 16 shows a schematic view of yet another display panel provided in some embodiments of the present application;
Fig. 17 shows a schematic structural view of a display panel provided in some embodiments of the present application;
Fig. 18 shows a schematic structural view of another display panel provided in some embodiments of the present application;
Fig. 19 shows a schematic structural view of yet another display panel provided in some embodiments of the present application;
Fig. 20 shows a schematic view of yet another display panel provided in some embodiments of the present application;
Fig. 21 shows a schematic view of yet another display panel provided in some embodiments of the present application; and
Fig. 22 shows a schematic view of a display device provided in some embodiments of the present application.

### DETAILED DESCRIPTION

In order to enable those skilled in the art to better understand the solutions of the present application, the technical solutions in the embodiments of the present application will be clearly and completely described below with reference to the drawings in the embodiments of the present application. It is obvious that, the described embodiments are only some embodiments of the present application, but not all embodiments. Based on the embodiments in the present application, all other embodiments obtained by those skilled in the art without inventive effort should belong to the protection scope of the present application.

It should be noted that, the terms "first", "second", among others in the description, the claims, and the drawings of the present application are used for distinguishing similar objects, while are not necessarily used for describing a specific order or sequence. It should be understood that, the data so used may be interchangeable where appropriate such that the embodiments of the application described herein may be practiced in an order other than those illustrated or described herein. Furthermore, the terms "comprising" and "having" and any variations thereof are intended to cover a non-exclusive inclusion. For example, a process, method, system, product, or apparatus comprising a series of steps or units is not necessarily limited to those steps or units clearly listed, but may include other steps or units not clearly listed or inherent to such process, method, product, or apparatus.

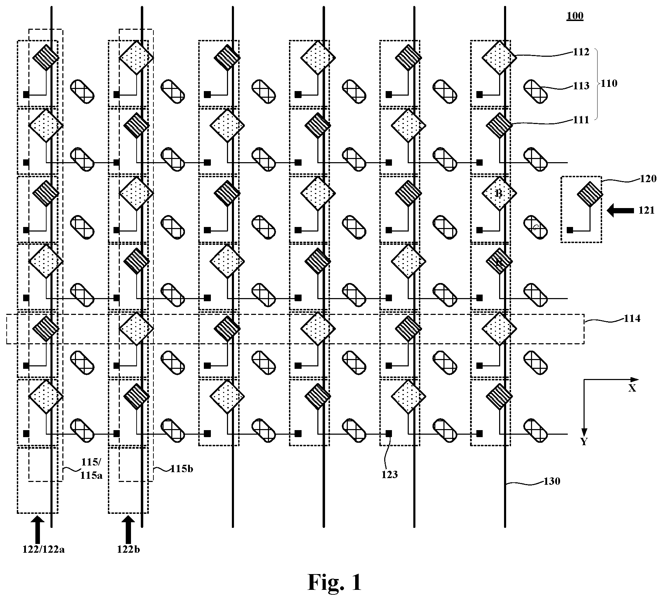

Fig. 1 shows a schematic view of a display panel provided in some embodiments of the present application. Referring to Fig. 1, the embodiments of the present application provide a display panel 100. The display panel 100 includes a plurality of light-emitting elements 110 and a plurality of first pixel circuits 120. The plurality of light-emitting elements 110 include at least first-color light-emitting elements 111 and second-color light-emitting elements 112, and color emitted by the first-color light-emitting elements 111 is different from color emitted by the second-color light-emitting elements 112. The plurality of light-emitting elements 110 include a plurality of first light-emitting element rows 114 arranged along a second direction Y and a plurality of first light-emitting element columns 115 arranged along a first direction X. Each first light-emitting element row 114 includes the first-color light-emitting elements 111 and the second-color light-emitting elements 112 alternately arranged along the first direction X, and each first light-emitting element column 115 includes the first-color light-emitting elements 111 and the second-color light-emitting elements 112 alternately arranged along the second direction Y. The first direction X is not parallel to the second direction Y. The plurality of first pixel circuits 120 include a plurality of first pixel circuit rows 121 arranged along the second direction Y and a plurality of first pixel circuit columns 122 arranged along the first direction X. Each first pixel circuit row 121 includes a plurality of first pixel circuits 120 arranged along the first direction X, and each first pixel circuit column 122 includes a plurality of first pixel circuits 120 arranged along the second direction Y. A plurality of light-emitting elements 110 that are electrically connected to a plurality of first pixel circuits 120, respectively, in one of the first pixel circuit rows 121 are in the same one of the first light-emitting element rows 114. For two adjacent first pixel circuit columns 122, each first pixel circuits 120 in one first pixel circuit column 122a is electrically connected to a respective first-color light-emitting element 111 in a first group of first light-emitting element columns 115 among the plurality of first light-emitting element columns 115, and each first pixel circuit 120 in another first pixel circuit column 122b is electrically connected to a respective second-color light-emitting element 112 in a second group of first light-emitting element columns 115 among the plurality of first light-emitting element columns 115.

It should be noted that, a specific configuration of the display panel 100 is not shown in Fig. 1, and only the connection relationships of components in local regions of the display panel 100 are schematically illustrated by simple lines, boxes, among others, which do not represent the actual layout design of the display panel 100.

In this embodiment, the display panel 100 includes a plurality of light-emitting elements 110. The plurality of light-emitting elements 110 of the display panel 100 include multiple types of light-emitting elements with different light-emitting colors. The plurality of light-emitting elements 110 include at least first-color light-emitting elements 111 with a first light-emitting color and second-color light-emitting elements 112 with a second light-emitting color, and the first color is different from the second color. Optionally, the plurality of light-emitting elements 110 of the display panel 100 in Fig. 1 further include third-color light-emitting elements 113 with a third light-emitting color, and the third color is different from the first color or the second color.

Referring to Fig. 1, the first color is red, the second color is blue, and the third color is green. That is, the first-color light-emitting elements 111 are red light-emitting elements R, the second-color light-emitting elements 112 are blue light-emitting elements B, and the third-color light-emitting elements 113 are green light-emitting elements G, but the present application is not limited thereto.

Optionally, in other embodiments, the first color is blue, and the second color and the third color are red and green respectively. Alternatively, the first color is green, and the second color and the third color are red and blue respectively. Alternatively, the light-emitting colors of the light-emitting elements of the display panel may be colors other than red, green, and blue, and relevant practitioners may reasonably design the types and quantities of the light-emitting colors of the light-emitting elements according to the requirements of the products.

The plurality of first-color light-emitting elements 111 and the plurality of second-color light-emitting elements 112 are alternately arranged in one row along the first direction X to form one first light-emitting element row 114. The plurality of first-color light-emitting elements 111 and the plurality of second-color light-emitting elements 112 are alternately arranged in one column along the second direction Y to form one first light-emitting element column 115. The display panel 100 includes a plurality of first light-emitting element rows 114 arranged along the second direction Y and a plurality of first light-emitting element columns 115 arranged along the first direction X. For each of the first-color light-emitting elements 111, the light-emitting elements 110 adjacent thereto in the first direction X and the light-emitting elements 110 adjacent thereto in the second direction Y are all second-color light-emitting elements 112. For each of the second-color light-emitting elements 112, the light-emitting elements 110 adjacent thereto in the first direction X and the light-emitting elements 110 adjacent thereto in the second direction Y are all first-color light-emitting elements 111. Referring to Fig. 1, the first direction X and the second direction Y intersect perpendicularly, but the present application is not limited thereto. In other embodiments, an angle between the first direction and the second direction may be an acute angle.

The display panel 100 includes a plurality of first pixel circuits 120, and each first pixel circuit 120 is electrically connected to a first-color light-emitting element 111 or a second-color light-emitting element 112 to drive the light-emitting elements 110, ensuring light-emitting display of the light-emitting elements 110. The plurality of first pixel circuits 120 are arranged in one row along the first direction X to form one first pixel circuit row 121. The plurality of first pixel circuits 120 are arranged in one column along the second direction Y to form one first pixel circuit column 122. The display panel 100 includes a plurality of first pixel circuit rows 121 arranged along the second direction Y and a plurality of first pixel circuit columns 122 arranged along the first direction X.

One first pixel circuit row 121 corresponds to one first light-emitting element row 114. That is, a plurality of first pixel circuits 120 in one first pixel circuit row 121 are electrically connected to a plurality of light-emitting elements 110 in the corresponding first light-emitting element row 114.

One first pixel circuit column 122 corresponds to one or more first light-emitting element columns 115. Here, the correspondence relationship between the first pixel circuit column 122 and the first light-emitting element column 115 means that there is an electrical connection and driving relationship between the first pixel circuits 120 in the first pixel circuit column 122 and the light-emitting elements 110 in a corresponding first light-emitting element column 115. A plurality of first pixel circuits 120 in the first pixel circuit column 122 are electrically connected to a plurality of first-color light-emitting elements 111 in one or more first light-emitting element columns 115. That is, the light-emitting elements 110 that are electrically connected to any two first pixel circuits 120 in the first pixel circuit column 122 have the same light-emitting color. Alternatively, a plurality of first pixel circuits 120 in the first pixel circuit column 122 are electrically connected to a plurality of second-color light-emitting elements 112 in one or more first light-emitting element columns 115. That is, the light-emitting elements 110 that are electrically connected to any two first pixel circuits 120 in the first pixel circuit column 122 have the same light-emitting color.

Exemplarily, the display panel 100 includes first pixel circuit columns 122a and first pixel circuit columns 122b adjacently arranged along the first direction X. The display panel 100 includes first light-emitting element columns 115a and first light-emitting element columns 115b adjacently arranged along the first direction X.

Referring to Fig. 1, the first pixel circuit column 122a corresponds to the first light-emitting element column 115a, and the first pixel circuit column 122b corresponds to the first light-emitting element column 115a and the first light-emitting element column 115b. A plurality of first pixel circuits 120 in the first pixel circuit column 122a are electrically connected to a plurality of first-color light-emitting elements 111 in the same first light-emitting element column 115a, and a plurality of first pixel circuits 120 in the first pixel circuit column 122b are electrically connected to a plurality of second-color light-emitting elements 112 in the first light-emitting element column 115a and a plurality of second-color light-emitting elements 112 in the first light-emitting element column 115b respectively. Therefore, the light-emitting elements 110 that are electrically connected to any two first pixel circuits 120 in one first pixel circuit column 122 have the same light-emitting color. It should be noted that, a configuration of each first pixel circuit 120 in Fig. 1 includes a via 123, and a first pixel circuit 120 is electrically connected to a light-emitting element 110 through the via 123.

The display panel 100 further includes a plurality of first data lines 130 which are configured to provide data signals to the first pixel circuits 120, thereby achieving driving of the light-emitting elements 110 by the first pixel circuits 120. Specifically, each first data line 130 extends along the second direction Y, and the plurality of first data lines 130 are arranged along the first direction X. One first data line 130 is provided corresponding to one first pixel circuit column 122. That is, a plurality of first pixel circuits 120 in a first pixel circuit column 122 are electrically connected to a corresponding same first data line 130, and the first data line 130 provides data signals to each of the first pixel circuits 120 in the same first pixel circuit column 122.

It should be noted that, a specific configuration of a first pixel circuit 120 is not shown in Fig. 1, and only a dashed-line box is used for representing one first pixel circuit 120. Thus, a specific electrical connection position between a first data line 130 and a first pixel circuit 120 is not explicitly shown. In Fig. 1, an electrical connection relationship between a first data line 130 and a first pixel circuit 120 is illustrated only by overlapping the first data line 130 and the first pixel circuit 120, without limitaion to an overlapping position and an overlapping area thereof. In addition, in Fig. 1, only one small black square is used for representing the via 123 of a first pixel circuit 120, and an electrical connection relationship between a first pixel circuit 120 and a light-emitting element 110 is schematically illustrated by electrically connecting the light-emitting element 110 to a via 123, but the electrical connection position is not limited thereby.

As described above, one first data line 130 is electrically connected to each of the first pixel circuits 120 in the same first pixel circuit column 122 and provides data signals to the first pixel circuits 120, and the first pixel circuits 120 are electrically connected to the light-emitting elements 110. The light-emitting elements 110 that are electrically connected to a plurality of first pixel circuits 120 in the same first pixel circuit column 122 are all first-color light-emitting elements 111, or the light-emitting elements 110 that are electrically connected to a plurality of first pixel circuits 120 in the same first pixel circuit column 122 are all second-color light-emitting elements 112. Therefore, one first data line 130 is configured to independently drive the plurality of first-color light-emitting elements 111, or one first data line 130 is configured to independently drive the plurality of second-color light-emitting elements 112. The first data lines 130 to which the first-color light-emitting elements 111 are electrically connected are different from the first data lines 130 to which the second-color light-emitting elements 112 are electrically connected, achieving that each of the first data lines 130 independently drives a plurality of light-emitting elements 110 with the same light-emitting color.

In the present application, the first light-emitting element columns each include the first-color light-emitting elements and the second-color light-emitting elements alternately arranged along the second direction, and the first pixel circuit columns each include the plurality of first pixel circuits arranged along the second direction. By optimizing the connection relationship between the light-emitting elements and the first pixel circuits, it enables that for two adjacent first pixel circuit columns, the first pixel circuits in one first pixel circuit column are electrically connected to the first-color light-emitting elements in at least one first light-emitting element column, and the first pixel circuits in the other first pixel circuit column are electrically connected to the second-color light-emitting elements in at least one first light-emitting element column. In the present application, a plurality of first pixel circuits in one first pixel circuit column drive a plurality of light-emitting elements with the same color, and thus a data line electrically connected to one pixel circuit column independently drives a plurality of light-emitting elements with the same light-emitting color. Therefore, there is no scenario that a plurality of light-emitting elements with different light-emitting colors share one data line. Accordingly, the data signals provided by the data line to light-emitting elements of different rows will not experience voltage jumps, which reduces a load on the data line, and thus reduces the power consumption of the display panel.

The above is the main concept of the present application, and the present application will be described in detail hereinafter by multiple embodiments.

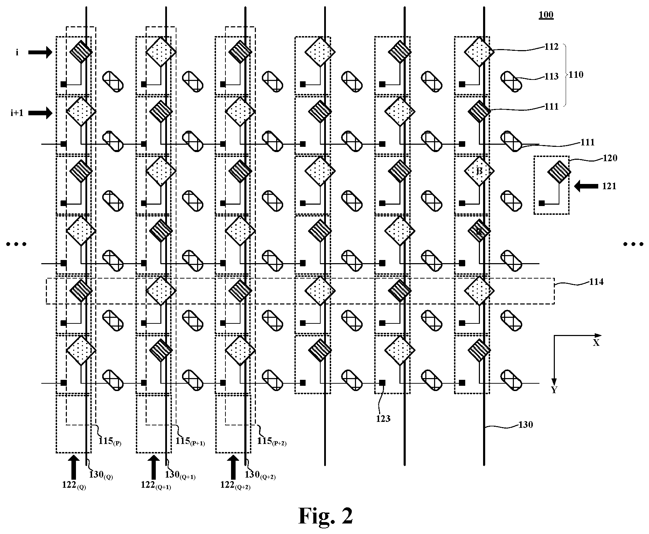

Fig. 2 shows a schematic view of another display panel provided in some embodiments of the present application. Optionally, as shown in Fig. 2, the plurality of first light-emitting element columns 115 includes at least the P-th first light-emitting element column 115_{(P)}, the (P+1)-th first light-emitting element column 115_{(P+1)}, and the (P+2)-th first light-emitting element column 115_{(P+2)}, which are adjacent first light-emitting element column sequentially arranged along the first direction X, where P ≥ 1; the plurality of first pixel circuit columns 122 include at least the Q-th first pixel circuit column 122_{(Q)}, the (Q+1)-th first pixel circuit column 122_{(Q+1)}, and the (Q+2)-th first pixel circuit column 122_{(Q+2)}, which are adjacent first light-emitting element column sequentially arranged along the first direction X, where Q ≥ 1; each first pixel circuit 120 in the (Q+1)-th first pixel circuit column 122_{(Q+1)} is electrically connected to a respective second-color light-emitting element 112 in a group of first light-emitting element columns 115 including the (P+1)-th first light-emitting element column 115_{(P+1)} and the P-th first light-emitting element column 115_{(P)}; and each first pixel circuit 120 in the (Q+2)-th first pixel circuit column 122_{(Q+2)} is electrically connected to a respective first-color light-emitting element 111 in a group of first light-emitting element columns 115 including the (P+2)-th first light-emitting element column 115_{(P+2)} and the (P+1)-th first light-emitting element column 115_{(P+1)}.

Optionally, in this embodiment, there are one or more first light-emitting element columns 115 (not shown) at one side of the P-th first light-emitting element column 115_{(P)} away from the (P+1)-th first light-emitting element column 115_{(P+1)}; and there are a plurality of first light-emitting element columns 115 at one side of the (P+2)-th first light-emitting element column 115_{(P+2)} away from the (P+1)-th first light-emitting element column 115_{(P+1)}.

Optionally, a plurality of first pixel circuits 120 in the Q-th first pixel circuit column 122_{(Q)} are electrically connected to a plurality of first-color light-emitting elements 111, a plurality of first pixel circuits 120 in the (Q+1)-th first pixel circuit column 122_{(Q+1}) are electrically connected to a plurality of second-color light-emitting elements 112, and a plurality of first pixel circuits 120 in the (Q+2)-th first pixel circuit column 122_{(Q+2)} are electrically connected to a plurality of first-color light-emitting elements 111.

In the Q-th first pixel circuit column 122_{(Q)}, there are a plurality of first pixel circuits 120 that are electrically connected to a plurality of first-color light-emitting elements 111 in the (P-1)-th first light-emitting element column 115_{(P-1)}; and in the Q-th first pixel circuit column 122_{(Q)}, there are also a plurality of first pixel circuits 120 that are electrically connected to a plurality of first-color light-emitting elements 111 in the P-th first light-emitting element column 115_{(P)}. The plurality of first pixel circuits 120 in the Q-th first pixel circuit column 122_{(Q)} are electrically connected to the same first data line 130_{(Q)}, and the first data line 130_{(Q)} is configured to drive the plurality of first-color light-emitting elements 111.

In the (Q+1)-th first pixel circuit column 122_{(Q+1)}, there are a plurality of first pixel circuits 120 that are electrically connected to a plurality of second-color light-emitting elements 112 in the P-th first light-emitting element column 115_{(P)}; and in the (Q+1)-th first pixel circuit column 122_{(Q+1)}, there are also a plurality of first pixel circuits 120 that are electrically connected to a plurality of second-color light-emitting elements 112 in the (P+1)-th first light-emitting element column 115_{(P+1)}. The plurality of first pixel circuits 120 in the (Q+1)-th first pixel circuit column 122_{(Q+1)} are electrically connected to the same first data line 130_{(Q+1)}, and the first data line 130_{(Q+1)} is configured to drive the plurality of second-color light-emitting elements 112.

In the (Q+2)-th first pixel circuit column 122_{(Q+2)}, there are a plurality of first pixel circuits 120 that are electrically connected to a plurality of first-color light-emitting elements 111 in the (P+1)-th first light-emitting element column 115_{(P+1)}; and in the (Q+2)-th first pixel circuit column 122_{(Q+2)}, there are also a plurality of first pixel circuits 120 that are electrically connected to a plurality of first-color light-emitting elements 111 in the (P+2)-th first light-emitting element column 115_{(P+2)}. The plurality of first pixel circuits 120 in the (Q+2)-th first pixel circuit column 122_{(Q+2)} are electrically connected to the same first data line 130_{(Q+2)}, and the first data line 130_{(Q+2)} is configured to drive the plurality of first-color light-emitting elements 111.

As described above, a plurality of first pixel circuits 120 in one first pixel circuit column 122 are electrically connected to a plurality of light-emitting elements 110 with the same light-emitting color, and a plurality of light-emitting elements 110 electrically connected to one first pixel circuit column 122 may be distributed in two adjacent first light-emitting element columns 115.

Optionally, referring to Fig. 2, a first pixel circuit 120 ranked i-th in sequential arrangement of the first pixel circuits in the (Q+1)-th first pixel circuit column 122_{(Q+1)} is electrically connected to a light-emitting element 110 ranked i-th in sequential arrangement of the light-emitting elements in the (P+1)-th first light-emitting element column 115_{(P+1)}, and a first pixel circuit 120 ranked (i+1)-th in sequential arrangement of the first pixel circuits in the (Q+1)-th first pixel circuit column 122_{(Q+1)} is electrically connected to a light-emitting element 110 ranked (i+1)-th in sequential arrangement of the light-emitting elements in the P-th first light-emitting element column 115_{(P)}; and a first pixel circuit 120 ranked i-th in sequential arrangement of the first pixel circuits in the (Q+2)-th first pixel circuit column 122_{(Q+2)} is electrically connected to a light-emitting element 110 ranked i-th in sequential arrangement of the light-emitting elements in the (P+2)-th first light-emitting element column 115_{(P+2)}, and a first pixel circuit 120 ranked (i+1)-th in sequential arrangement of the first pixel circuits in the (Q+2)-th first pixel circuit column 122_{(Q+2)} is electrically connected to a light-emitting element 110 ranked (i+1)-th in sequential arrangement of the light-emitting elements in the (P+1)-th first light-emitting element column 115_{(P+1)}.

In this embodiment, the light-emitting element 110 that is electrically connected to the 1st first pixel circuit 120 in one first pixel circuit column 122 is located in the 1st first light-emitting element row 114, and the light-emitting element 110 that is electrically connected to the 2nd first pixel circuit 120 in one first pixel circuit column 122 is located in the 2nd first light-emitting element row 114. In this manner, the light-emitting element 110 that is electrically connected to the i-th first pixel circuit 120 in the first pixel circuit column 122 is located in the i-th first light-emitting element row 114, and the light-emitting element 110 that is electrically connected to the (i+1)-th first pixel circuit 120 in the first pixel circuit column 122 is located in the (i+1)-th first light-emitting element row 114.

Optionally, the i-th light-emitting element 110 in the (P+1)-th first light-emitting element column 115_{(P+1)} is a second-color light-emitting element 112, and the (i+1)-th light-emitting element 110 in the (P+1)-th first light-emitting element column 115_{(P+1)} is a first-color light-emitting element 111; in an adjacent P-th first light-emitting element column 115_{(P)}, the i-th light-emitting element 110 is a first-color light-emitting element 111, and the (i+1)-th light-emitting element 110 is a second-color light-emitting element 112; and in the adjacent (P+2)th first light-emitting element column 115_{(P+2)}, the i-th light-emitting element 110 is a first-color light-emitting element 111, and the (i+1)-th light-emitting element 110 is a second-color light-emitting element 112.

The i-th first pixel circuit 120 in the (Q+1)-th first pixel circuit column 122_{(Q+1)} is electrically connected to the i-th light-emitting element 110 in the (P+1)-th first light-emitting element column 115_{(P+1)}, and the (i+1)-th first pixel circuit 120 in the (Q+1)-th first pixel circuit column 122_{(Q+1)} is electrically connected to the (i+1)-th light-emitting element 110 in the P-th first light-emitting element column 115_{(P)}. Therefore, the light-emitting elements 110 that are electrically connected the plurality of first pixel circuits 120 in the (Q+1)-th first pixel circuit column 122_{(Q+1)} are all second-color light-emitting elements 112. The first data line 130_{(Q+1)} drives the plurality of second-color light-emitting elements 112 through the plurality of first pixel circuits 120 in the (Q+1)-th first pixel circuit column 122_{(Q+1)}.

The i-th first pixel circuit 120 in the (Q+2)-th first pixel circuit column 122_{(Q+2)} is electrically connected to the i-th light-emitting element 110 in the (P+2)-th first light-emitting element column 115_{(P+2)}, and the (i+1)-th first pixel circuit 120 in the (Q+2)-th first pixel circuit column 122_{(Q+2)} is electrically connected to the (i+1)-th light-emitting element 110 in the (P+1)-th first light-emitting element column 115_{(P+1)}. Therefore, the light-emitting elements 110 that are electrically connected to the plurality of first pixel circuits 120 in the (Q+2)-th first pixel circuit column 122_{(Q+2)} are all first-color light-emitting elements 111. The first data line 130_{(Q+2)} drives the plurality of first-color light-emitting elements 111 through the plurality of first pixel circuits 120 in the (Q+2)-th first pixel circuit column 122_{(Q+2)}.

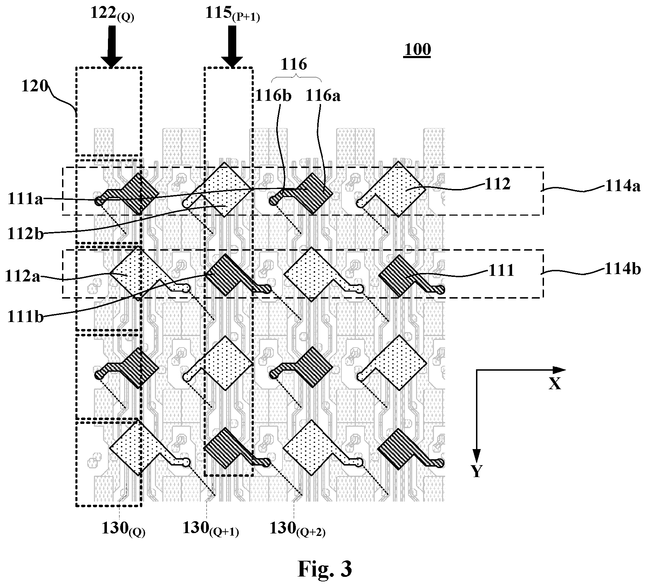

Fig. 3 shows a schematic structural view of the display panel shown in Fig. 2. Optionally, as shown in Figs. 2 and 3, the display panel 100 further includes a plurality of first data lines 130 arranged along the first direction X, each first data line 130 extends along the second direction Y, and a plurality of first pixel circuits 120 connected to one (or each) of first data line 130 are in the same one of the first pixel circuit columns 122; each light-emitting element 110 includes an anode 116, and the anode 116 includes an anode main body portion 116a and an anode connection portion 116b that are connected to each other; for each second-color light-emitting element 112 in the (P+1)-th first light-emitting element column 115_{(P+1)}, the anode connection portion 116b is located at a side of the anode main body portion 116a away from the first data line 130_{(Q+1)} electrically connected to the (Q+1)-th first pixel circuit column 122_{(Q+1)}, and for each second-color light-emitting element 112 in the P-th first light-emitting element column 115_{(P)}, the anode connection portion 116b is located at a side of the anode main body portion 116a close to the first data line 130_{(Q+1)} electrically connected to the (Q+1)-th first pixel circuit column 122_{(Q+1)}; and for each first-color light-emitting element 111 in the (P+1)-th first light-emitting element column 115_{(P+1)}, the anode connection portion 116b is located at a side of the anode main body portion 116a close to the first data line 130_{(Q+2)} electrically connected to the (Q+2)-th first pixel circuit column 122_{(Q+2)}, and for each first-color light-emitting element 111 in the (P+2)-th first light-emitting element column 115_{(P+2)}, the anode connection portion 116b is located at a side of the anode main body portion 116a away from the first data line 130_{(Q+2)} electrically connected to the (Q+2)-th first pixel circuit column 122_{(Q+2)}. Optionally, each light-emitting element 110 includes an anode 116, and the anode 116 includes an anode main body portion 116a and an anode connection portion 116b that are connected to each other; and for each first light-emitting element row 114, the anode connection portion 116b of each light-emitting element 110 in the first light-emitting element row 114 is located at the same side of an anode main body portion 116a.

There are various configuration methods of the pixel circuits in the display panel, and the pixel circuits may have a "7T1C" structure, an "8T1C" structure, or other structures. There are multiple types of transistors in the pixel circuits, such as N-type transistors or P-type transistors. Based on various configuration methods of the pixel circuits and the transistors therein, those skilled in the art may adjust the pixel circuits and the transistors therein according to actual needs.

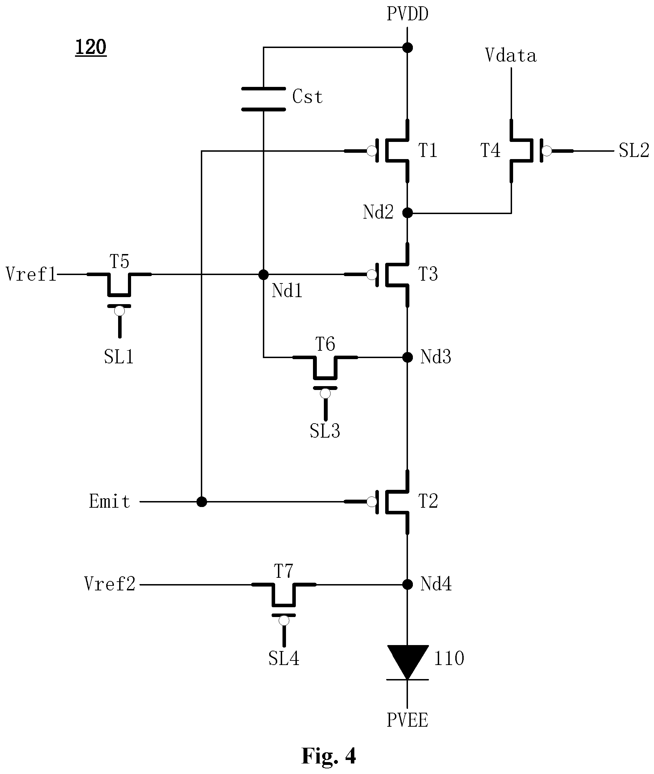

Fig. 4 shows a schematic view of a first pixel circuit provided in some embodiments of the present application. Referring to Fig. 4, in this embodiment, the first pixel circuit 120 is illustrated taking a "7T1C" structure as an example. The first pixel circuit 120 may include a first light-emitting control transistor T1, a second light-emitting control transistor T2, a drive transistor T3, a data write transistor T4, an initialization reset transistor T5, a threshold compensation transistor T6, an anode reset transistor T7, and a storage capacitor Cst. Optionally, a transistor in the first pixel circuit 120 may include a Low Temperature Poly-Silicon (LTPS) transistor, which has advantages such as high switching speed, high carrier mobility, and low power consumption. The first pixel circuit 120 is electrically connected to a light-emitting element 110, and the first pixel circuit 120 is also electrically connected to a first data line.

Specifically, the control terminal of the initialization reset transistor T5 is connected to a first scan signal line SL1, the input terminal of the initialization reset transistor T5 is connected to an initialization reset signal line Vref1, the output terminal of the initialization reset transistor T5 is connected to a node Nd1, and the node Nd1 is connected to the gate of the drive transistor T3. A signal provided by the first scan signal line SL1 can control the initialization reset transistor T5 to turn on or off, and a first reset signal provided by the initialization reset signal line Vref1 is written to the gate of the drive transistor T3 when the initialization reset transistor T5 is turned on.

The storage capacitor Cst may ensure that the potential of the node Nd1 is stable.

The control terminal of the data write transistor T4 is connected to a second scan signal line SL2, the input terminal of the data write transistor T4 is connected to a data line, i.e., a first data line Vdata, the output terminal of the data write transistor T4 is connected to a node Nd2, and the node Nd2 is connected to the first terminal of the drive transistor T3. A signal provided by the second scan signal line SL2 can control the data write transistor T4 to turn on or off, and a data signal supplied by the first data line Vdata is written to the first terminal of the drive transistor T3 when the data write transistor T4 is turned on.

The control terminal of the threshold compensation transistor T6 is connected to a third scan signal line SL3, the first terminal of the threshold compensation transistor T6 is connected to the node Nd1, the second terminal of the threshold compensation transistor T6 is connected to a node Nd3, and the node Nd3 is connected to the second terminal of the drive transistor T3. A signal supplied by the third scan signal line SL3 can control the threshold compensation transistor T6 to turn on or off, thereby achieving threshold voltage compensation for the drive transistor T3 when the threshold compensation transistor T6 is turned on.

The control terminal of the anode reset transistor T7 is connected to a fourth scan signal line SL4, the input terminal of the anode reset transistor T7 is connected to an anode reset signal line Vref2, the output terminal of the anode reset transistor T7 is connected to a node Nd4, and the node Nd4 is connected to the anode of the light-emitting element 110. A signal provided by the fourth scan signal line SL4 can control the anode reset transistor T7 to turn on or off, and a second reset signal provided by the anode reset signal line Vref2 can be written to the anode of the light-emitting element 110 when the anode reset transistor T7 is turned on to achieve reset of the anode of the light-emitting element 110.

The control terminal of the first light-emitting control transistor T1 and the control terminal of the second light-emitting control transistor T2 are both connected to a light-emitting control signal line Emit, and the light-emitting control signal line Emit can control the first light-emitting control transistor T1 and the second light-emitting control transistor T2 to turn on or off. A power signal provided by a power signal line PVDD is written to the anode of the light-emitting element 110 when the first light-emitting control transistor T1 and the second light-emitting control transistor T2 are both turned on to achieve display and light-emission of the light-emitting element 110.

It may be seen from Figs. 3 and 4 that, the anode main body portion 116a of the light-emitting element 110 is connected to other different transistors in the first pixel circuit 120 through the anode connection portion 116b and a bridge structure. For example, the anode main body portion 116a of the light-emitting element 110 may be connected to the output terminal of the anode reset transistor T7 through the anode connection portion 116b and a bridge structure; and the anode main body portion 116a of the light-emitting element 110 may be connected to the second terminal of the drive transistor T3 through the anode connection portion 116b and another bridge structure.

The anode main body portion 116a and the anode connection portion 116b of the light-emitting element 110 may be arranged on a same layer. The bridge structure for connecting the anode connection portion 116b of the light-emitting element 110 may be formed on another metal film layer.

Exemplarily, the (P+2)-th first light-emitting element column 115_{(P+2)} includes first-color light-emitting elements 111a, the P-th first light-emitting element column 115_{(P)} includes second-color light-emitting elements 112a, and the (P+1)-th first light-emitting element column 115_{(P+1)} includes adjacent first-color light-emitting elements 111b and second-color light-emitting elements 112b.

The second-color light-emitting elements 112b of the (P+1)-th first light-emitting element column 115_{(P+1)} are electrically connected to the first pixel circuits 120 of the (Q+1)-th first pixel circuit column 122_{(Q+1)}, and the first data line 130_{(Q+1)} is electrically connected to the (Q+1)-th first pixel circuit column 122_{(Q+1)}. The anode connection portion 116b of each second-color light-emitting element 112b is located on one side of the anode main body portion 116a thereof away from the first data line 130_{(Q+1)}.

The second-color light-emitting elements 112a of the P-th first light-emitting element column 115_{(P)} are electrically connected to the first pixel circuits 120 of the (Q+1)-th first pixel circuit column 122_{(Q+1)}, and the anode connection portion 116b of each second-color light-emitting element 112a is located on one side of the anode main body portion 116a thereof close to the first data line 130_{(Q+1)}.

The first-color light-emitting elements 111b of the (P+1)-th first light-emitting element column 115_{(P+1)} are electrically connected to the first pixel circuits 120 of the (Q+2)-th first pixel circuit column 122_{(Q+2)}, and the first data line 130_{(Q+2)} is electrically connected to the (Q+2)-th first pixel circuit column 122_{(Q+2)}. The anode connection portion 116b of each first-color light-emitting elements 111b is located on one side of the anode main body portion 116a thereof close to the first data line 130_{(Q+2)}.

The first-color light-emitting elements 111a in the (P+2)-th first light-emitting element column 115_{(P+2)} are electrically connected to the first pixel circuits 120 of the (Q+2)-th first pixel circuit column 122_{(Q+2)}, and the anode connection portion 116b of each first-color light-emitting element 111a is located on one side of the anode main body portion 116a thereof away from the first data line 130_{(Q+2)}.

The display panel 100 includes first light-emitting element rows 114a and first light-emitting element rows 114b adjacently arranged. Optionally, the light-emitting element 110 has a first side and a second side along the first direction X. For any one of the light-emitting elements 110 in the first light-emitting element rows 114a, the anode connection portion 116b of the light-emitting element 110 is located on the first side of the anode main body portion 116a thereof; and for any one of the light-emitting elements 110 in the first light-emitting element rows 114b, the anode connection portion 116b of the light-emitting element 110 is located on the second side of the anode main body portion 116a thereof.

It should be noted that, referring to Fig. 3 as an example, by reasonably designing the relative positions of the anode connection portion 116b and the anode main body portion 116a of the light-emitting elements 110 with different light-emitting colors, the layout change of the display panel 100 may be reduced, and structures such as cross-lines do not need to be added, which has a relatively high practicality.

In this embodiment, two light-emitting elements with different light-emitting colors are electrically connected to two different data lines, and one data line provides data signals to a plurality of light-emitting elements with the same light-emitting color. Accordingly, voltage jumps will not occur when one same data line provides data signals to a plurality of light-emitting elements in different rows, which reduces a load on the data line, and thus reduces the power consumption of the display panel. In addition, in this embodiment, only the relative position between the anode connection portion and the anode main body portion of the anode of each first-color light-emitting element, and the relative position between the anode connection portion and the anode main body portion of the anode of each second-color light-emitting element need to be simply adjusted to achieve that one data line provides data signals to a plurality of light-emitting elements with the same light-emitting color, which may reduce the production complexity.

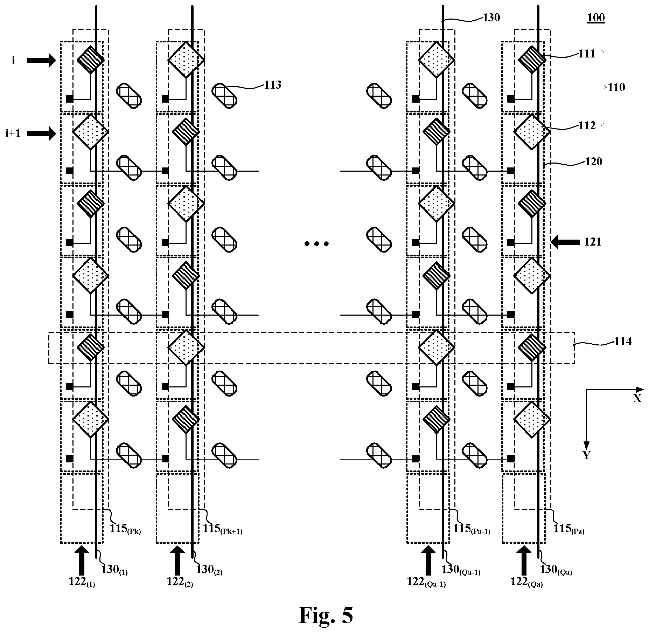

Fig. 5 shows a schematic view of yet another display panel provided in some embodiments of the present application. Optionally, as shown in Fig. 5, the plurality of first light-emitting element columns 115 includes at least the (Pa-1)-th first light-emitting element column 115_{(Pa-1)} and the Pa-th first light-emitting element column 115_{(Pa)} that are adjacent to each other, where Pa ≥ 2; the plurality of first pixel circuit columns 122 include Qa first pixel circuit columns arranged in an order of a 1st first pixel circuit column 122₍₁₎ through a Qa-th first pixel circuit column 122_{(Qa)}, where Qa ≥ 3; and along the first direction X, the first-color light-emitting elements 111 that are electrically connected to a plurality of first pixel circuits 120, respectively, in the 1st first pixel circuit column 122₍₁₎ are in the same Pk-th first light-emitting element column 115_{(Pk)}, and a plurality of first pixel circuits 120 in the Qa-th first pixel circuit column 122_{(Qa)} are electrically connected to a plurality of first-color light-emitting elements 111, respectively, in a group of first light-emitting element columns 115 comprising the Pa-th first light-emitting element column 115_{(Pa)} and the (Pa-1)-th first light-emitting element column 115_{(Pa-1)}.

In this embodiment, the plurality of first pixel circuit columns 122 include the 1st first pixel circuit column 122₍₁₎ to the Qa-th first pixel circuit column 122_{(Qa)} arranged in sequence along the first direction X. The light-emitting elements 110 that are electrically connected to the first pixel circuits 120 in the 1st first pixel circuit column 122₍₁₎ and the light-emitting elements 110 that are electrically connected to the first pixel circuits 120 in the Qa-th first pixel circuit column 122_{(Qa)} have the same light-emitting color, which may be the first-color light-emitting elements 111. Optionally, the i-th light-emitting element 110 in the Pa-th first light-emitting element column 115_{(Pa)} is a first-color light-emitting element 111, and the (i+1)-th light-emitting element 110 in the Pa-th first light-emitting element column 115_{(Pa)} is a second-color light-emitting element 112; and in the adjacent (Pa-1)-th first light-emitting element column 115_{(Pa-1)}, the i-th light-emitting element 110 is a second-color light-emitting element 112, and the (i+1)-th light-emitting element 110 is a first-color light-emitting element 111.

A plurality of first pixel circuits 120 in the 1st first pixel circuit column 122₍₁₎ are electrically connected to a plurality of first-color light-emitting elements 111 in the Pk-th first light-emitting element column 115_{(Pk)}. If Pk is equal to 1, the odd-numbered first pixel circuits 120 in the 1st first pixel circuit column 122₍₁₎ may be electrically connected to the light-emitting elements 110.

A plurality of first pixel circuits 120 in the Qa-th first pixel circuit column 122_{(Qa)} are electrically connected to a plurality of first-color light-emitting elements 111 in the Pa-th first light-emitting element column 115_{(Pa)} and a plurality of first-color light-emitting elements 111 in the (Pa-1)-th first light-emitting element column 115_{(Pa-1)}. Specifically, the i-th first pixel circuit 120 in the Qa-th first pixel circuit column 122_{(Qa)} is electrically connected to the i-th light-emitting element 110 in the Pa-th first light-emitting element column 115_{(Pa)}, and the (i+1)-th first pixel circuit 120 in the Qa-th first pixel circuit column 122_{(Qa)} is electrically connected to the (i+1)-th light-emitting element 110 in the (Pa-1)-th first light-emitting element column 115_{(Pa-1)}. Therefore, the light-emitting elements 110 that are electrically connected the plurality of first pixel circuits 120 in the Qa-th first pixel circuit column 122_{(Qa)} are all the first-color light-emitting elements 111. The first data line 130_{(Qa)} that is electrically connected to the Qa-th first pixel circuit column 122_{(Qa)} drives the plurality of first-color light-emitting elements 111.

It should be noted that, referring to Fig. 5 as an example, a plurality of first pixel circuits 120 in the 1st first pixel circuit column 122₍₁₎ are electrically connected to a plurality of first-color light-emitting elements 111 in the Pk-th first light-emitting element column 115_{(Pk)}, but there is at least one first pixel circuit 120 which is not connected to any one of the light-emitting elements 110 in the 1st first pixel circuit column 122₍₁₎. For the first pixel circuit 120 which is not connected to any one of the light-emitting elements 110, it is disconnected from the anode of the light-emitting element 110, and belongs to an idle first pixel circuit 120. The connection relationship between the idle first pixel circuit 120 and the signal line is not strictly limited.

Referring to Fig. 4, if the shown first pixel circuit 120 is an idle pixel circuit, for example, the first pixel circuit 120 may be disconnected from the first scan signal line SL1; alternatively, in other embodiments, the idle pixel circuit may be connected to signal lines like a conventional pixel circuit; alternatively, in other embodiments, at least one signal terminal of the idle pixel circuit may be connected to a signal line providing a fixed voltage. Those skilled in the art may flexibly design the connection relationship between the idle pixel circuit and the signal line according to the needs.

In this embodiment, the first pixel circuits 120 in the 1st first pixel circuit column 122₍₁₎ and the Qa-th first pixel circuit column 122_{(Qa)} located on two opposite edges of the display panel 100 are all electrically connected to the first-color light-emitting elements 111. That is, the light-emitting elements 110 on two edges of the display panel 100 have the same light-emitting color. When displaying a solid color screen, the display effects of two edges of the display panel 100 may be uniform, the display color bias difference between the two edges of the display panel 100 may be reduced, and the display uniformity may be improved. In addition, the first data line 130 provides data signals to a plurality of light-emitting elements 110 with a same light-emitting color. Accordingly, voltage jumps will not occur when one same first data line 130 provides data signals to a plurality of light-emitting elements 110 in different rows, which reduces a load on the data line, and thus reduces the power consumption of the display panel.

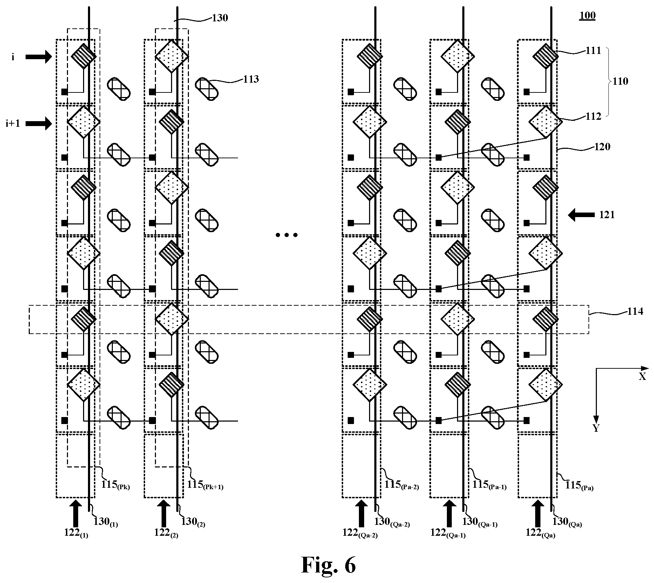

Fig. 6 shows a schematic view of yet another display panel provided in some embodiments of the present application. Fig. 6 is different from Fig. 5 in that, a plurality of second-color light-emitting elements 112 in the Pa-th first light-emitting element column 115_{(Pa)} in Fig. 6 are electrically connected to a plurality of first pixel circuits 120, respectively, in the (Qa-1)-th first pixel circuit column 122_{(Qa-1)}.

In this embodiment, there is no other first pixel circuit column 122 on one side of the Qa-th first pixel circuit column 122_{(Qa)} away from the (Qa-1)-th first pixel circuit column 122_{(Qa-1)}, and the Qa-th first pixel circuit column 122_{(Qa)} is the last first pixel circuit column 122 of the display panel 100. A plurality of first-color light-emitting elements 111 in the Pa-th first light-emitting element column 115_{(Pa)} may be electrically connected to a plurality of first pixel circuits 120 in the Qa-th first pixel circuit column 122_{(Qa)}. A plurality of second-color light-emitting elements 112 in the Pa-th first light-emitting element column 115_{(Pa)} may be electrically connected to a plurality of first pixel circuits 120 in the (Qa-1)-th first pixel circuit column 122_{(Qa-1)} adjacent to the Qa-th first pixel circuit column 122_{(Qa)}, thereby reducing a display difference between an edge of the display panel 100 and other display areas, and improving display uniformity.

Optionally, referring to Fig. 6, the first pixel circuit 120 ranked i-th in sequential arrangement of the first pixel circuits in the (Qa-1)-th first pixel circuit column 122_{(Qa-1)} is electrically connected to the light-emitting element 110 ranked i-th in sequential arrangement of the light-emitting elements in the (Pa-1)-th first light-emitting element column 115_{(Pa-1)}, and the first pixel circuit 120 ranked (i+1)-th in sequential arrangement of the first pixel circuits in the (Qa-1)-th first pixel circuit column 122_{(Qa-1)} is electrically connected to the light-emitting element 110 ranked (i+1)-th in sequential arrangement of the light-emitting elements in the Pa-th first light-emitting element column 115_{(Pa)} and the light-emitting element 110 ranked (i+1)-th in sequential arrangement of the light-emitting elements in the (Pa-2)-th first light-emitting element column 115_{(Pa-2)}.

In this embodiment, the first pixel circuits 120 in the Qa-th first pixel circuit column 122_{(Qa)} are electrically connected to the first-color light-emitting elements 111, and the plurality of first pixel circuits 120 in the (Qa-1)-th first pixel circuit column 122_{(Qa-1)} adjacent to the Qa-th first pixel circuit column 122_{(Qa)} are electrically connected to the second-color light-emitting elements 112.

Specifically, the i-th first pixel circuit 120 in the (Qa-1)-th first pixel circuit column 122_{(Qa-1)} is electrically connected to the i-th light-emitting element 110 in the (Pa-1)-th first light-emitting element column 115_{(Pa-1)}, and the (i+1)-th first pixel circuit 120 in the (Qa-1)-th first pixel circuit column 122_{(Qa-1)} is electrically connected to the (i+1)-th light-emitting element 110 in the (Pa-2)-th first light-emitting element column 115_{(Pa-2)} and the (i+1)-th light-emitting element 110 in the Pa-th first light-emitting element column 115_{(Pa)}. Therefore, the light-emitting elements 110 that are electrically connected to the plurality of first pixel circuits 120 in the (Qa-1)-th first pixel circuit column 122_{(Qa-1)} are all second-color light-emitting elements 112. The first data line 130_{(Qa-1)} that is electrically connected to the (Qa-1)-th first pixel circuit column 122_{(Qa-1)} simultaneously drives the second-color light-emitting elements 112 in three adjacent first light-emitting element columns 115, and thus it may achieve simultaneous driving of the second-color light-emitting elements 112 of the (Pa-2)-th first light-emitting element column 115_{(Pa-2)}, the (Pa-1)-th first light-emitting element column 115_{(Pa-1)}, and the Pa-th first light-emitting element column 115_{(Pa)} without adding the first data line 130.

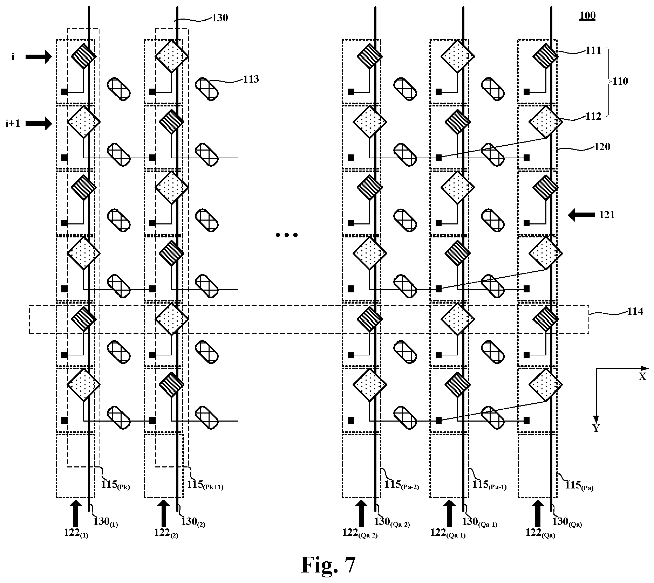

Fig. 7 shows a schematic structural view of the display panel shown in Fig. 6. As illustrated in Figs. 6 and 7, exemplarily, the (Qa-1)-th first pixel circuit column 122_{(Qa-1)} includes a first pixel circuit 120a that is electrically connected to a second-color light-emitting element 112c in the Pa-th first light-emitting element column 115_{(Pa)} and a second-color light-emitting element 112d in the (Pa-2)-th first light-emitting element column 115_{(Pa-2)}. The second-color light-emitting element 112c is electrically connected to the first pixel circuit 120a by a bridge portion 117.

In this embodiment, a plurality of first-color light-emitting elements 111 in the Pa-th first light-emitting element column 115_{(Pa)} may be electrically connected to a plurality of first pixel circuits 120 in the Qa-th first pixel circuit column 122_{(Qa)}, and a plurality of second-color light-emitting elements 112 in the Pa-th first light-emitting element column 115_{(Pa)} may be electrically connected to a plurality of first pixel circuits 120 in the (Qa-1)-th first pixel circuit column 122_{(Qa-1)} adjacent to the Qa-th first pixel circuit column 122_{(Qa)}. Under this condition, any one of the light-emitting elements 110 in the Pa-th first light-emitting element column 115_{(Pa)} participates in the display, thereby improving a display effect of an edge of the display panel 100, reducing a display difference between the edge of the display panel 100 and other display areas, and improving display uniformity. In addition, the first data line 130 provides data signals to a plurality of light-emitting elements 110 with the same light-emitting color. Accordingly, voltage jumps will not occur when one same first data line 130 provides data signals to a plurality of light-emitting elements 110 in different rows, which reduces the load on the data line, and thus reduces the power consumption of the display panel.

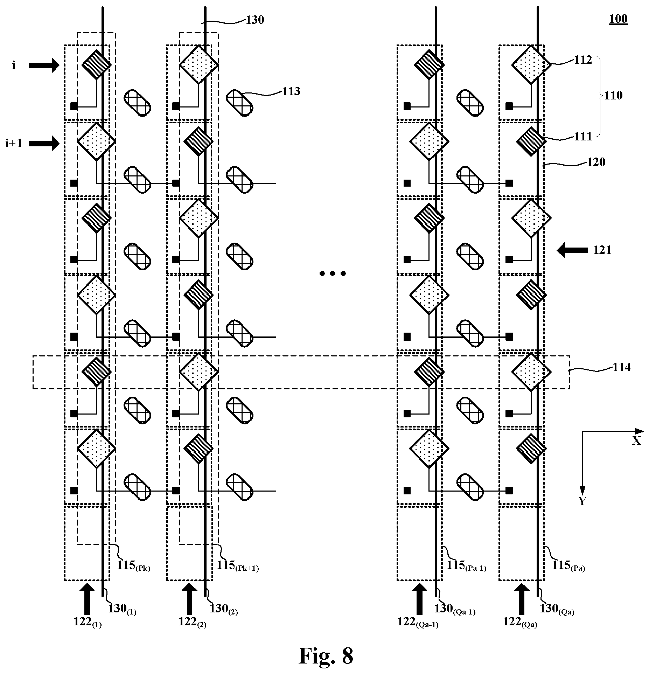

Fig. 8 shows a schematic view of yet another display panel provided in some embodiments of the present application. Optionally, as shown in Fig. 8, the plurality of first light-emitting element columns 115 includes at least the (Pa-1)-th first light-emitting element column 115_{(Pa-1)} and the Pa-th first light-emitting element column 115_{(Pa)} that are adjacent to each other, where Pa ≥ 2; the plurality of first pixel circuit columns 122 include Qa first pixel circuit columns arranged in an order of a 1st first pixel circuit column through a Qa-th first pixel circuit column, where Qa ≥ 3; and along the first direction X, the first-color light-emitting elements that are electrically connected to a plurality of first pixel circuits 120, respectively, in the 1st first pixel circuit column 122₍₁₎ are in the same Pk-th first light-emitting element column 115_{(Pk)}, and a plurality of first pixel circuits 120 in the Qa-th first pixel circuit column 122_{(Qa)} are electrically connected to a plurality of second-color light-emitting elements 112, respectively, in a group of first light-emitting element columns 115 comprising the Pa-th first light-emitting element column 115_{(Pa)} and the (Pa-1)-th first light-emitting element column 115_{(Pa-1)}.

Fig. 8 is different from Fig. 5 in that, in the display panel 100 shown in Fig. 8, the light-emitting elements 110 that are electrically connected to the first pixel circuits 120 in the 1st first pixel circuit column 122₍₁₎ have a different light-emitting color from the light-emitting elements 110 that are electrically connected to the first pixel circuits 120 in the Qa-th first pixel circuit column 122_{(Qa)}. A plurality of first pixel circuits 120 in the 1st first pixel circuit column 122₍₁₎ are electrically connected to a plurality of first-color light-emitting elements 111 in the Pk-th first light-emitting element column 115_{(Pk)}. A plurality of first pixel circuits 120 in the Qa-th first pixel circuit column 122_{(Qa)} are electrically connected to a plurality of second-color light-emitting elements 112 in the Pa-th first light-emitting element column 115_{(Pa)} and a plurality of second-color light-emitting elements 112 in the (Pa-1)-th first light-emitting element column 115_{(Pa-1)}.

In this embodiment, for the 1st first pixel circuit column 122₍₁₎ and the Qa-th first pixel circuit column 122_{(Qa)} located on two opposite edges of the display panel 100, the first pixel circuits 120 in the 1st first pixel circuit column 122₍₁₎ are electrically connected to the first-color light-emitting elements 111, and the first pixel circuits 120 in the Qa-th first pixel circuit column 122_{(Qa)} are electrically connected to the second-color light-emitting elements 112. Since the first data line 130₍₁₎ electrically connected to the first pixel circuits 120 in the 1st first pixel circuit column 122₍₁₎ drives a less number of light-emitting elements 110 than other data lines, the load of the first data line 130₍₁₎ is small, the driving ability thereof is stronger, and thus the plurality of first-color light-emitting elements 111 in the first light-emitting element column 115_{(Pk)} may be quickly charged by the first data line 130₍₁₎. If the first-color light-emitting elements 111 are blue light-emitting elements having a low light-emitting efficiency. Under a condition that the number of light-emitting elements 110 driven by the first data line 130₍₁₎ is less than that of other data lines, a charging speed of the blue light-emitting elements may be improved.

In addition, the first data line 130 provides data signals to a plurality of light-emitting elements 110 with the same light-emitting color. Accordingly, voltage jumps will not occur when one same first data line 130 provides data signals to a plurality of light-emitting elements 110 in different rows, which reduces the load on the data line, and thus reduces the power consumption of the display panel.

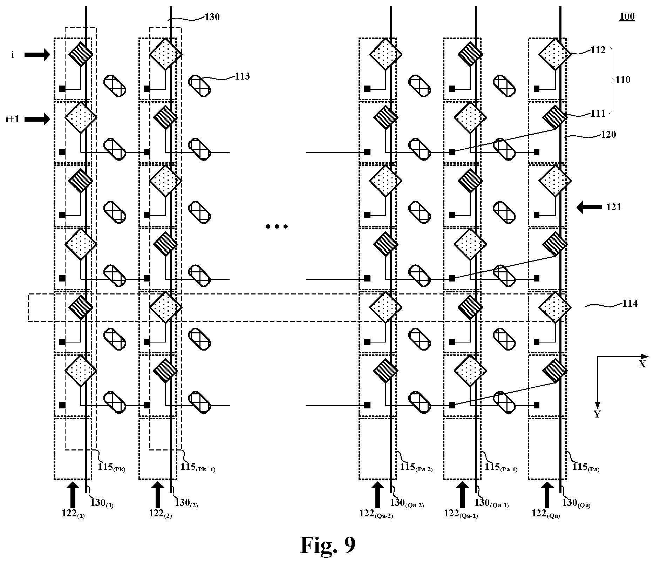

Fig. 9 shows a schematic view of yet another display panel provided in some embodiments of the present application. Optionally, a plurality of first-color light-emitting elements 111 in the Pa-th first light-emitting element column 115_{(Pa)} are electrically connected to a plurality of first pixel circuits 120, respectively, in the (Qa-1)-th first pixel circuit column 122_{(Qa-1)}.

In this embodiment, the Qa-th first pixel circuit column 122_{(Qa)} is the last first pixel circuit column 122 of the display panel 100. A plurality of second-color light-emitting elements 112 in the Pa-th first light-emitting element column 115_{(Pa)} are electrically connected to a plurality of first pixel circuits 120 in the Qa-th first pixel circuit column 122_{(Qa)}. Optionally, a plurality of first-color light-emitting elements 111 in the Pa-th first light-emitting element column 115_{(Pa)} are electrically connected to a plurality of first pixel circuits 120 in the (Qa-1)-th first pixel circuit column 122_{(Qa-1)} adjacent to the Qa-th first pixel circuit column 122_{(Qa)}, thereby reducing a display difference between an edge of the display panel 100 and other display areas, and improving display uniformity.

A plurality of first pixel circuits 120 in the (Qa-1)-th first pixel circuit column 122_{(Qa-1)} are electrically connected to the first-color light-emitting elements 111. Specifically, the i-th first pixel circuit 120 in the (Qa-1)-th first pixel circuit column 122_{(Qa-1)} is electrically connected to the i-th light-emitting element 110 in the (Pa-1)-th first light-emitting element column 115_{(Pa-1)}, and the (i+1)-th first pixel circuit 120 in the (Qa-1)-th first pixel circuit column 122_{(Qa-1)} is electrically connected to the (i+1)-th light-emitting element 110 in the (Pa-2)-th first light-emitting element column 115_{(Pa-2)} and the (i+1)-th light-emitting element 110 in the Pa-th first light-emitting element column 115_{(Pa)}. The first data line 130_{(Qa-1)} simultaneously drives the plurality of first-color light-emitting elements 111 in three adjacent first light-emitting element columns 115, and thus it may achieve simultaneous driving of the first-color light-emitting elements 111 in the (Pa-2)-th first light-emitting element column 115_{(Pa-2)}, the (Pa-1)-th first light-emitting element column 115_{(Pa-1)}, and the Pa-th first light-emitting element column 115_{(Pa)} without adding the first data line 130.

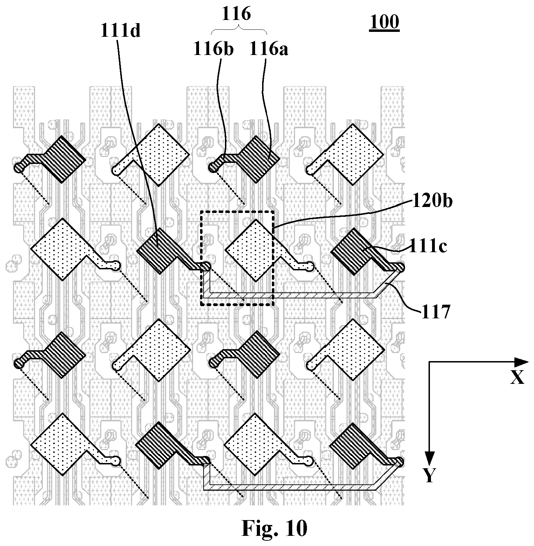

Fig. 10 shows a schematic structural view of the display panel shown in Fig. 9. As shown in Figs. 9 and 10, exemplarily, the (Qa-1)-th first pixel circuit column 122_{(Qa-1)} includes a first pixel circuit 120b that is electrically connected to a first-color light-emitting element 111c in the Pa-th first light-emitting element column 115_{(Pa)} and a first-color light-emitting element 111d in the (Pa-2)-th first light-emitting element column 115_{(Pa-2)}. The first-color light-emitting element 111c is electrically connected to the first pixel circuit 120b by the bridge portion 117.

In this embodiment, a plurality of second-color light-emitting elements 112 in the Pa-th first light-emitting element column 115_{(Pa)} may be electrically connected to a plurality of first pixel circuits 120 in the Qa-th first pixel circuit column 122_{(Qa)}, and a plurality of first-color light-emitting elements 111 in the Pa-th first light-emitting element column 115_{(Pa)} may be electrically connected to a plurality of first pixel circuits 120 in the (Qa-1)-th first pixel circuit column 122_{(Qa-1)} adjacent to the Qa-th first pixel circuit column 122_{(Qa)}. Under this condition, any one of the light-emitting elements 110 in the Pa-th first light-emitting element column 115_{(Pa)} participates in the display, thereby improving a display effect of an edge of the display panel 100, reducing a display difference between the edge of the display panel 100 and other display areas, and improving display uniformity. In addition, the first data line 130 provides data signals to a plurality of light-emitting elements 110 with the same light-emitting color. Accordingly, voltage jumps will not occur when one same first data line 130 provides data signals to a plurality of light-emitting elements 110 in different rows, which reduces the load on the data line, and thus reduces the power consumption of the display panel.

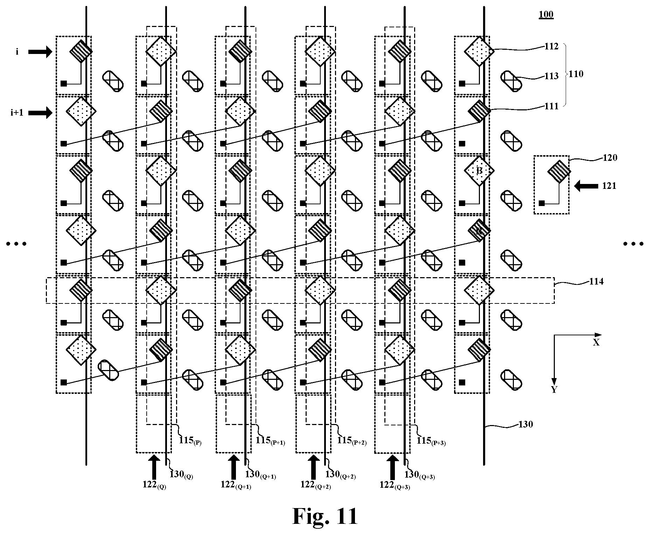

Fig. 11 shows a schematic view of yet another display panel provided in some embodiments of the present application. Optionally, as shown in Fig. 11, the plurality of first light-emitting element columns 115 includes at least the P-th first light-emitting element column 115_{(P)}, the (P+1)-th first light-emitting element column 115_{(P+1)}, the (P+2)-th first light-emitting element column 115_{(P+2)}, and the (P+3)-th first light-emitting element column 115_{(P+3)} adjacently arranged along the first direction X, which are adjacent first light-emitting element column sequentially, where P ≥ 1; the plurality of first pixel circuit columns 122 include at least the Q-th first pixel circuit column 122_{(Q)}, the (Q+1)-th first pixel circuit column 122_{(Q+1)}, the (Q+2)-th first pixel circuit column 122_{(Q+2)}, and the (Q+3)-th first pixel circuit column 122_{(Q+3)} adjacently arranged along the first direction X, which are adjacent first light-emitting element column sequentially, where Q ≥ 1; each first pixel circuit 120 in the (Q+1)-th first pixel circuit column 122_{(Q+1)} is electrically connected to a respective first-color light-emitting element 111 in a group of first light-emitting element columns 115 comprising the (P+1)-th first light-emitting element column 115_{(P+1)} and the (P+2)-th first light-emitting element column 115_{(P+2)}; and each first pixel circuit 120 in the (Q+2)-th first pixel circuit column 122_{(Q+2)} is electrically connected to a respective second-color light-emitting element 112 in a group of first light-emitting element columns 115 comprising the (P+2)-th first light-emitting element column 115_{(P+2)} and the (P+3)-th first light-emitting element column 115_{(P+3)}.

Optionally, referring to Fig. 11, the first pixel circuit 120 ranked i-th in sequential arrangement of the first pixel circuits in the (Q+1)-th first pixel circuit column 122_{(Q+1)} is electrically connected to the light-emitting element 110 ranked i-th in sequential arrangement of the light-emitting elements in the (P+1)-th first light-emitting element column 115_{(P+1)}, and the first pixel circuit 120 ranked (i+1)-th in sequential arrangement of the first pixel circuits in the (Q+1)-th first pixel circuit column 122_{(Q+1)} is electrically connected to the light-emitting element 110 ranked (i+1)-th in sequential arrangement of the first pixel circuits in the (P+2)-th first light-emitting element column 115_{(P+2)}; and the first pixel circuit 120 ranked i-th in sequential arrangement of the first pixel circuits in the (Q+2)-th first pixel circuit column 122_{(Q+2)} is electrically connected to the light-emitting element 110 ranked i-th in sequential arrangement of the light-emitting elements in the (P+2)-th first light-emitting element column 115_{(P+2)}, and the first pixel circuit 120 ranked (i+1)-th in sequential arrangement of the first pixel circuits in the (Q+2)-th first pixel circuit column 122_{(Q+2)} is electrically connected to the light-emitting element 110 ranked (i+1)-th in sequential arrangement of the first pixel circuits in the (P+3)-th first light-emitting element column 115_{(P+3)}.

Optionally, in this embodiment, a plurality of first pixel circuits 120 in one first pixel circuit column 122 are electrically connected to a plurality of first-color light-emitting elements 111 in two adjacent first light-emitting element columns 115, or a plurality of first pixel circuits 120 in one first pixel circuit column 122 are electrically connected to a plurality of second-color light-emitting elements 112 in two adjacent first light-emitting element columns 115.

Specifically, in the (Q+1)-th first pixel circuit column 122_{(Q+1)}, there are a plurality of first pixel circuits 120 that are electrically connected to a plurality of first-color light-emitting elements 111 in the (P+1)-th first light-emitting element column 115_{(P+1)}, and in the (Q+1)-th first pixel circuit column 122_{(Q+1)}, there are also a plurality of first pixel circuits 120 that are electrically connected to a plurality of first-color light-emitting elements 111 in the (P+2)-th first light-emitting element column 115_{(P+2)}. The first data line 130_{(Q+1)} electrically connected to the first pixel circuits 120 in the (Q+1)-th first pixel circuit column 122_{(Q+1)} is configured to drive a plurality of first-color light-emitting elements 111.

In the (Q+2)-th first pixel circuit column 122_{(Q+2)}, there are a plurality of first pixel circuits 120 that are electrically connected to a plurality of second-color light-emitting elements 112 in the (P+2)-th first light-emitting element column 115_{(P+2)}, and in the (Q+2)-th first pixel circuit column 122_{(Q+2)}, there are also a plurality of first pixel circuits 120 that are electrically connected to a plurality of second-color light-emitting elements 112 in the (P+3)-th first light-emitting element column 115_{(P+3)}. The first data line 130_{(Q+2)} electrically connected to the first pixel circuits 120 in the (Q+2)-th first pixel circuit column 122_{(Q+2)} is configured to drive a plurality of second-color light-emitting elements 112.

As described above, a plurality of first pixel circuits 120 in one first pixel circuit column 122 are electrically connected to a plurality of light-emitting elements 110 with the same light-emitting color, and a plurality of light-emitting elements 110 electrically connected to one first pixel circuit column 122 may be distributed in two adjacent first light-emitting element columns 115.

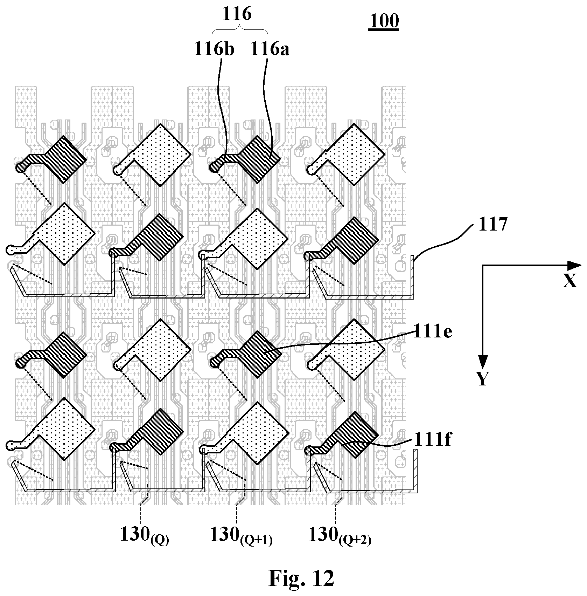

Fig. 12 shows a schematic structural view of the display panel shown in Fig. 11. Optionally, as shown in Figs. 11 and 12, the display panel 100 further includes a plurality of first data lines 130 arranged along the first direction X, each first data line 130 extends along the second direction Y, and a plurality of first pixel circuits 120 connected to one (or each) of first data line 130 are in the same one of the first pixel circuit columns 122; each light-emitting element 110 includes an anode 116, and the anode 116 includes an anode main body portion 116a and an anode connection portion 116b that are connected to each other; the display panel 100 includes a plurality of bridge portions 117; for each second-color light-emitting element 112 in the (P+2)-th first light-emitting element column 115_{(P+2)}, the anode connection portion 116b is located at a side of the anode main body portion 116a away from the first data line 130_{(Q+2)} electrically connected to the (Q+2)-th first pixel circuit column 122_{(Q+2)}, and for each second-color light-emitting element 112 in the (P+3)-th first light-emitting element column 115_{(P+3)}, the anode connection portion 116b is electrically connected to a respective first pixel circuit 120 in the (Q+2)-th first pixel circuit column 122_{(Q+2)} through a respective one of the bridge portions 117; and for each first-color light-emitting element 111 in the (P+1)-th first light-emitting element column 115_{(P+1)}, the anode connection portion 116b is located at a side of the anode main body portion 116a away from the first data line 130_{(Q+1)} electrically connected to the (Q+1)-th first pixel circuit column 122_{(Q+1)}, and for each first-color light-emitting element 111 in the (P+2)-th first light-emitting element column 115_{(P+2)}, the anode connection portion 116b is electrically connected to a respective first pixel circuit 120 in the (Q+1)-th first pixel circuit column 122_{(Q+1)} through a respective one of the bridge portions 117.

Exemplarily, the anode connection portion 116b of each light-emitting element 110 may be located on the same side of the anode main body portion 116a thereof. The (P+1)-th first light-emitting element column 115_{(P+1)} includes a first-color light-emitting element 111e, and the (P+2)-th first light-emitting element column 115_{(P+2)} includes a first-color light-emitting element 111f. The plurality of first pixel circuits 120 in the (Q+1)-th first pixel circuit column 122_{(Q+1)} are electrically connected to the first data line 130_{(Q+1)}. The first data line 130_{(Q+1)} is electrically connected to the first-color light-emitting element 111e and the first-color light-emitting element 111f.

In this embodiment, two light-emitting elements with different light-emitting colors are electrically connected to two different data lines, and one data line provides data signals to a plurality of light-emitting elements with the same light-emitting color. Accordingly, voltage jumps will not occur when one same data line provides data signals to a plurality of light-emitting elements in different rows, which reduces a load on the data line, and thus reduces the power consumption of the display panel.

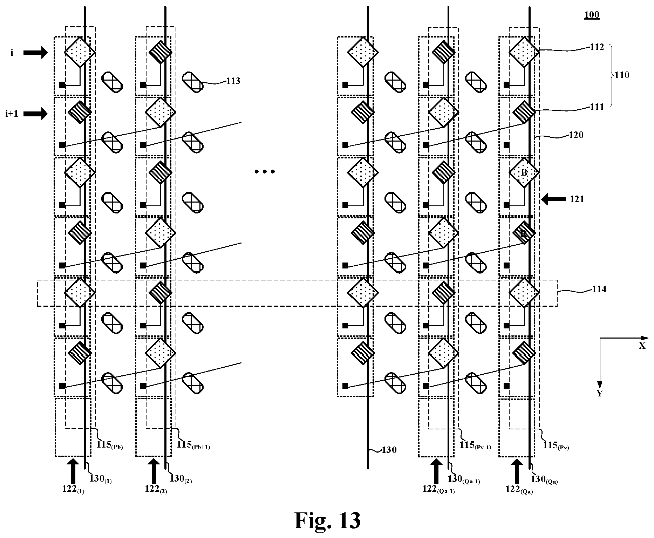

Fig. 13 shows a schematic view of yet another display panel provided in some embodiments of the present application. Optionally, the plurality of first light-emitting element columns 115 includes at least the Pb-th first light-emitting element column 115_{(Pb)} and the (Pb+1)-th first light-emitting element column 115_{(Pb+1)} that are adjacent to each other, where Pb ≥ 1; the plurality of first pixel circuit columns 122 include Qa first pixel circuit columns arranged in an order of a 1st first pixel circuit column through a Qa-th first pixel circuit column, where Qa ≥ 3; and along the first direction X, a plurality of first pixel circuits 120 in the 1st first pixel circuit column 122₍₁₎ are electrically connected to a plurality of second-color light-emitting elements 112, respectively, in a group of first light-emitting element columns 115 comprising the Pb-th first light-emitting element column 115_{(Pb)} and the (Pb+1)-th first light-emitting element column 115_{(Pb+1)}, and a plurality of second-color light-emitting elements 112 that are electrically connected to a plurality of first pixel circuits 120, respectively, in the Qa-th first pixel circuit column 122_{(Qa)} in the same Pv-th first light-emitting element column 115_{(Pv)}.

In this embodiment, the light-emitting elements 110 that are electrically connected to the first pixel circuits 120 in the 1st first pixel circuit column 122₍₁₎ and the light-emitting elements 110 that are electrically connected to the first pixel circuits 120 in the Qa-th first pixel circuit column 122_{(Qa)} have the same light-emitting color, which may be the second-color light-emitting elements 112. The first pixel circuits 120 in the Qa-th first pixel circuit column 122_{(Qa)} are electrically connected to a plurality of second-color light-emitting elements 112 in the Pv-th first light-emitting element column 115_{(Pv)}.

In other embodiments, the light-emitting elements that are electrically connected to the first pixel circuits in the 1st first pixel circuit column may have a different light-emitting color from the light-emitting elements that are electrically connected to the first pixel circuits in the Qa-th first pixel circuit column, which is not specifically limited here.

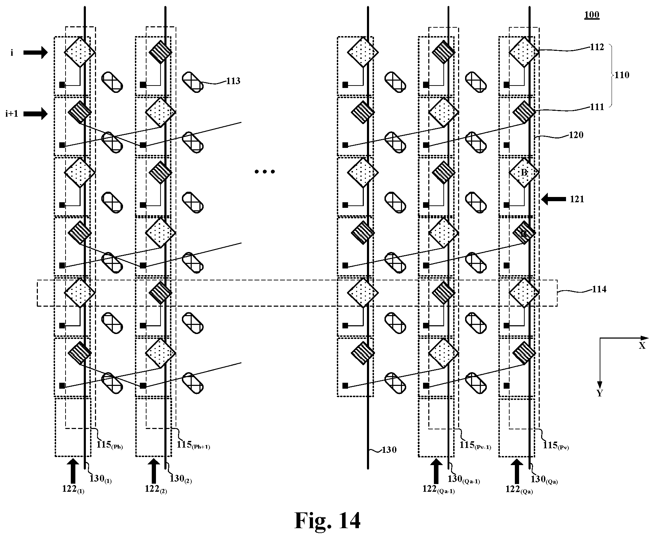

Fig. 14 shows a schematic view of yet another display panel provided in some embodiments of the present application. Fig. 14 is different from Fig. 13 in that, a plurality of first-color light-emitting elements 111 in the Pb-th first light-emitting element column 115_{(Pb)} in Fig. 14 are electrically connected to a plurality of first pixel circuits 120, respectively, in the 2nd first pixel circuit column 122₍₂₎. Optionally, the pixel circuit 120 ranked i-th in sequential arrangement of the first pixel circuits in the 2nd first pixel circuit column 122₍₂₎ is electrically connected to the light-emitting element 110 ranked i-th in sequential arrangement of the light-emitting elements in the (Pb+1)-th first light-emitting element column 115_{(Pb+1)}, and the first pixel circuit 120 ranked (i+1)-th in sequential arrangement of the first pixel circuits in the 2nd first pixel circuit column 122₍₂₎ is electrically connected to the light-emitting element 110 ranked (i+1)-th in sequential arrangement of the light-emitting elements in the Pb-th first light-emitting element column 115_{(Pb)} and the light-emitting element 110 ranked (i+1)-th in sequential arrangement of the light-emitting elements in the (Pb+2)-th first light-emitting element column 115_{(Pb+2)}. Accordingly, the first data line 130₍₂₎ that is electrically connected to the 2nd first pixel circuit column 122₍₂₎ simultaneously drives a plurality of first-color light-emitting elements 111 in three adjacent first light-emitting element columns 115, such that one first data line 130 drives the plurality of light-emitting elements 110 with the same light-emitting color.

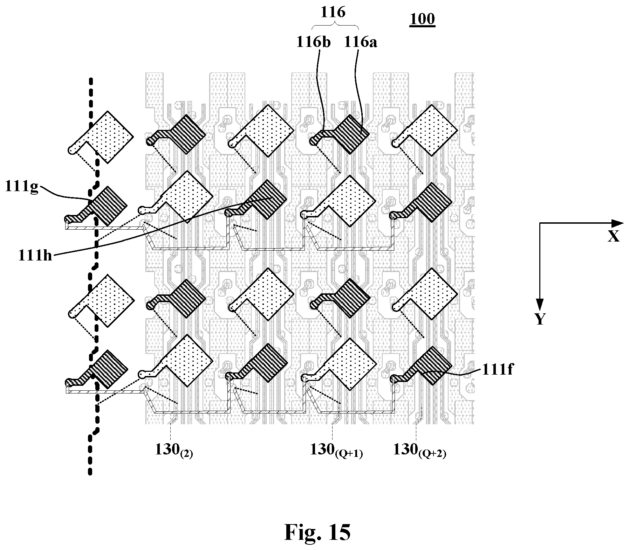

Fig. 15 shows a schematic structural view of the display panel shown in Fig. 14. As shown in Figs. 14 and 15, exemplarily, the anode connection portion 116b of each light-emitting element 110 is located on the same side of the anode main body portion 116a thereof. The Pb-th first light-emitting element column 115_{(Pb)} includes a first-color light-emitting element 111g, and the (Pb+2)-th first light-emitting element column 115_{(Pb+2)} includes a first-color light-emitting element 111h. The plurality of first pixel circuits 120 in the 2nd first pixel circuit column 122₍₂₎ are electrically connected to the first data line 130₍₂₎.The first data line 130₍₂₎ is electrically connected to the first-color light-emitting element 111g and the first-color light-emitting element 111h.

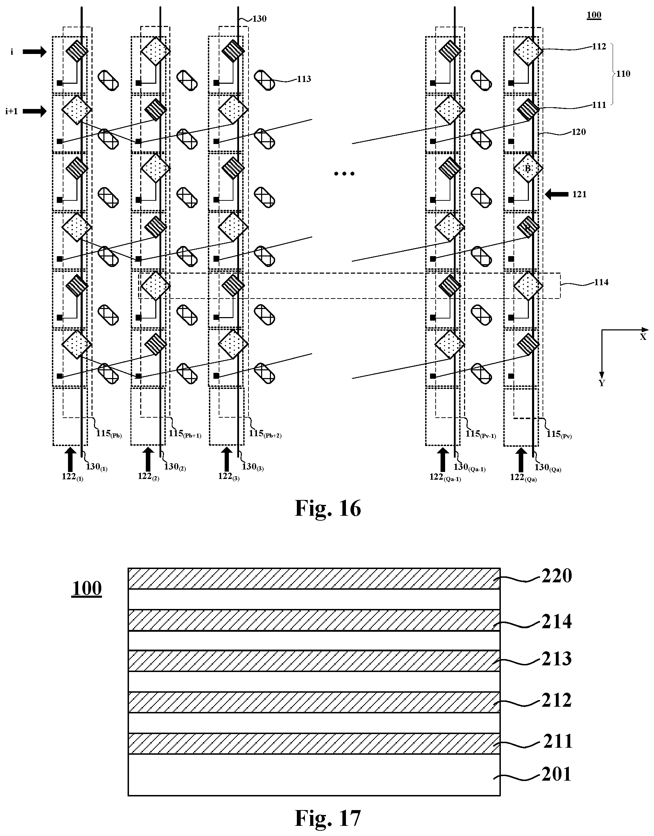

Fig. 16 shows a schematic view of yet another display panel provided in some embodiments of the present application. Optionally, the plurality of first light-emitting element columns 115 includes at least the Pb-th first light-emitting element column 115_{(Pb)} and the (Pb+1)-th first light-emitting element column 115_{(Pb+1)} that are adjacent to each other, where Pb ≥ 1; the plurality of first pixel circuit columns 122 include Qa first pixel circuit columns arranged in an order of a 1st first pixel circuit column 122₍₁₎ through a Qa-th first pixel circuit column, where Qa ≥ 3; and along the first direction X, a plurality of first pixel circuits 122 in the 1st first pixel circuit column 122₍₁₎ are electrically connected to a plurality of first-color light-emitting elements 111, respectively, in the Pb-th first light-emitting element column 115_{(Pb)}, and the second-color light-emitting elements 112 that are electrically connected to a plurality of first pixel circuits 120, respectively, in the Qa-th first pixel circuit column 122_{(Qa)} are in the same v-th first light-emitting element column 115_{(Pv)}. In this embodiment, the light-emitting elements 110 that are electrically connected to the first pixel circuits 120 in the 1st first pixel circuit column 122₍₁₎ have a different light-emitting color from the light-emitting elements 110 that are electrically connected to the first pixel circuits 120 in the Qa-th first pixel circuit column 122_{(Qa)}, which is not specifically limited here.

Optionally, referring to Fig. 16, a plurality of second-color light-emitting elements 112 in the Pb-th first light-emitting element column 115_{(Pb)} are electrically connected to a plurality of first pixel circuits 120, respectively, in the 2nd first pixel circuit column 122₍₂₎. A first data line 130₍₂₎ that is electrically connected to the 2nd first pixel circuit column 122₍₂₎ may simultaneously drive a plurality of second-color light-emitting elements 112 in three adjacent first light-emitting element columns 115.

Fig. 17 shows a schematic structural view of a display panel provided in some embodiments of the present application. Optionally, as shown in Fig. 17, the display panel 100 includes a substrate 201, and the film layer in which the bridge portion is located is between the film layer of the anode 220 and the film layer of the substrate 201.

Specifically, the different film layers of the display panel 100 are illustrated from the bottom up one by one, and the film layers include at least the substrate 201, a first semiconductor layer 211, a first metal layer 212, a second metal layer 213, a third metal layer 214, and the anode 220 of a light-emitting element in sequence. It should be noted that, the film layers of the display panel 100 are not limited to those illustrated above. There are other film layers in the display panel 100, such as a buffer layer, other metal layers and semiconductor layers, and insulating film layers are also provided between functional film layers. About the specific film layer arrangement of the display panel 100, adaptive adjustments may be made according to the actual production requirements, such as adding or removing some film layers, which are not specifically limited in the embodiments of the present application.

The film layer of the bridge portion for connecting the light-emitting element and the first pixel circuit may be disposed between the film layer of the anode 220 and the film layer of the substrate 201. For example, the film layer of the bridge portion may be located on the third metal layer 214, but the present application is not limited thereto.

Optionally, each first pixel circuit includes at least one transistor, and each transistor of the at least one transistor includes a first active layer; each first pixel circuit further includes a storage capacitor, the storage capacitor includes a first plate and a second plate arranged opposite to each other, and the second plate is located on one side of the first plate away from the first active layer; the display panel further includes a first semiconductor layer, a first metal layer, a second metal layer, and a third metal layer; the first active layer is located on the first semiconductor layer, the first plate is located on the first metal layer, the second plate is located on the second metal layer, and the third metal layer is located on one side of the second metal layer away from the first active layer; and each bridge portion is located in at least one of the first metal layer, the second metal layer, or the third metal layer.

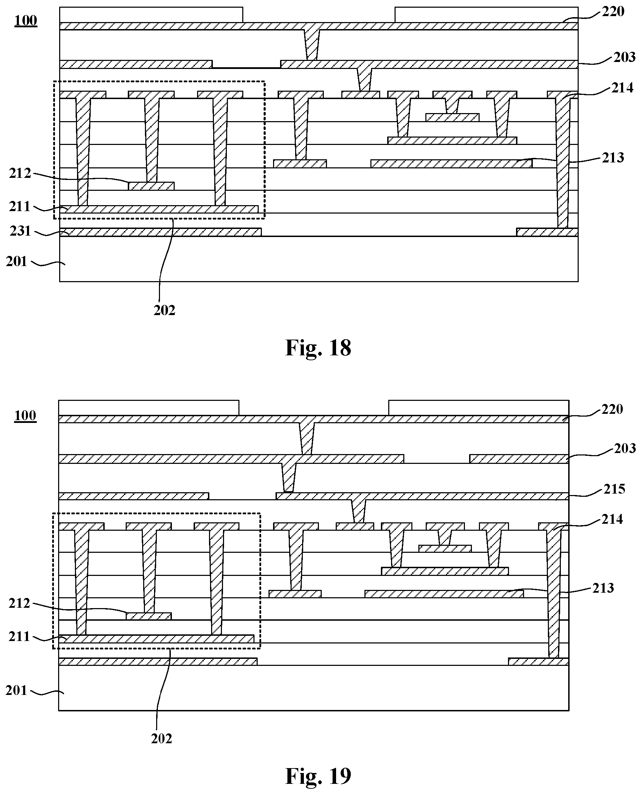

Fig. 18 shows a schematic structural view of another display panel provided in some embodiments of the present application. As shown in Figs. 17 and 18, in this embodiment, the display panel 100 includes a first semiconductor layer 211. The first pixel circuit includes at least one transistor 202, and the transistor 202 includes a first active layer that is located on the first semiconductor layer 211. Optionally, the first active layer is poly.

The display panel 100 further includes a first metal layer 212, a second metal layer 213, and a third metal layer 214. The first pixel circuit further includes a storage capacitor which includes a first plate and a second plate arranged opposite to each other. Optionally, the first plate is located on the first metal layer 212, the second plate is located on the second metal layer 213, and the third metal layer 214 is located at the side of the second metal layer 213 away from the first active layer 211.

The bridge portion is located on the first metal layer 212; alternatively, the bridge portion is located on the second metal layer 213; alternatively, the bridge portion is located on the third metal layer 214.

The first pixel circuit includes at least one transistor 202. The gate of the transistor 202 may be located on the first metal layer 212, and the source and drain of the transistor 202 may be located on the third metal layer 214. The film layer 203 on which the data lines are located may be provided on the side of the third metal layer 214 away from the first active layer 211. The film layer 203 on which the data lines are located includes a plurality of first data lines, and each of the first data lines is electrically connected to the anode 220 of a light-emitting element through a first pixel circuit. Referring to Fig. 4, a first data line (denoted by Vdata in Fig. 4) is connected to the source of the data write transistor T4 of the first pixel circuit 120, and the anode 220 of the light-emitting element 110 is connected to the drain of the drive transistor T3 through an anode connection portion.

Optionally, each first pixel circuit includes at least one transistor, and each transistor of the at least one transistor includes a first active layer; each first pixel circuit further includes a storage capacitor, the storage capacitor includes a first plate and a second plate arranged opposite to each other, and the second plate is located at the side of the first plate away from the first active layer; the display panel further includes a first semiconductor layer, a first metal layer, a second metal layer, a third metal layer, and a fourth metal layer; the first active layer is located on the first semiconductor layer, the first plate is located on the first metal layer, the second plate is located on the second metal layer, the third metal layer is located at the side of the second metal layer away from the first active layer, and the fourth metal layer is located at the side of the third metal layer away from the first active layer; and each bridge portion is located in at least one of the first metal layer, the second metal layer, the third metal layer, or the fourth metal layer.

Fig. 19 shows a schematic structural view of yet another display panel provided in some embodiments of the present application. As shown in Figs. 17 and 19, in this embodiment, the display panel 100 includes a first semiconductor layer 211. The first pixel circuit includes at least one transistor 202, and the transistor 202 includes a first active layer that is located on the first semiconductor layer 211. Optionally, the first active layer is poly.

The display panel 100 further includes a first metal layer 212, a second metal layer 213, a third metal layer 214, and a fourth metal layer 215. The first pixel circuit further includes a storage capacitor which includes a first plate and a second plate arranged opposite to each other. Optionally, the first plate is located on the first metal layer 212, the second plate is located on the second metal layer 213, the third metal layer 214 is located at the side of the second metal layer 213 away from the first active layer 211, and the fourth metal layer 215 is located at the side of the third metal layer 214 away from the first active layer 211.

The bridge portion is located on the first metal layer 212; alternatively, the bridge portion is located on the second metal layer 213; alternatively, the bridge portion is located on the third metal layer 214; alternatively, the bridge portion is located on the fourth metal layer 215.

The first pixel circuit includes at least one transistor 202. The gate of the transistor 202 may be located on the first metal layer 212, and the source and drain of the transistor 202 may be located on the third metal layer 214. The film layer 203 on which the data lines are located may be provided at the side of the fourth metal layer 215 away from the first active layer 211. The film layer 203 on which the data lines are located includes a plurality of first data lines, and each of the first data lines is electrically connected to the anode 220 of a light-emitting element through a first pixel circuit. Referring to Fig. 4, a first data line (denoted by Vdata in Fig. 4) is connected to the source of the data write transistor T4 of the first pixel circuit 120, and the anode 220 of the light-emitting element 110 is connected to the drain of the drive transistor T3 through an anode connection portion.

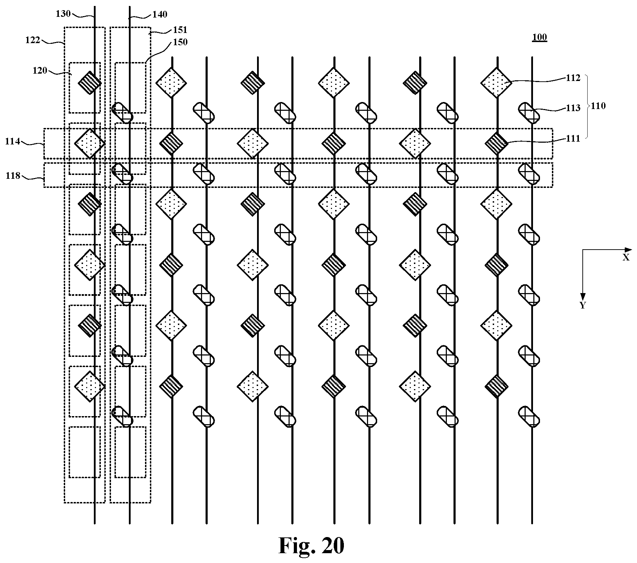

Fig. 20 shows a schematic view of yet another display panel provided in some embodiments of the present application. As shown in Fig. 20, the display panel 100 further includes a plurality of first data lines 130, each first data lines 130 being arranged along the first direction X, each first data line 130 extending along the second direction Y, and a plurality of first pixel circuits 120 connected to one (or each) of the first data line 130 are in the same one of the first pixel circuit columns 122; a plurality of second data lines 140, the plurality of second data lines 140 being arranged along the first direction X, each of the second data lines 140 extending along the second direction Y; and a plurality of second pixel circuit columns 151 arranged along the first direction X, each second pixel circuit columns 151 including a plurality of second pixel circuits 150 arranged along the second direction Y, the second pixel circuits 150 in each second pixel circuit column 151 being electrically connected to the same one of second data lines 140, where the plurality of light-emitting elements 110 include first-color light-emitting elements 111, second-color light-emitting elements 112, and third-color light-emitting elements 113, and each second pixel circuits 150 is electrically connected to a respective one of the third-color light-emitting elements 113. The first data lines 130 and the second data lines 140 are alternately arranged along the first direction X. The plurality of light-emitting elements 110 further include second light-emitting element rows 118. The second light-emitting element rows 118 and the first light-emitting element rows 114 are alternately arranged along the second direction Y. Each second light-emitting element rows 118 includes a plurality of third-color light-emitting elements 113 arranged along the first direction X.

In this embodiment, the plurality of light-emitting elements 110 of the display panel 100 include first-color light-emitting elements 111, second-color light-emitting elements 112, and third-color light-emitting elements 113. The second pixel circuits 150 are electrically connected to the third-color light-emitting elements 113. One second data line 140 is electrically connected to one corresponding second pixel circuit column 151, and the second data line 140 drives the plurality of third-color light-emitting elements 113.

The first data lines 130 and the second data lines 140 are alternately arranged along the first direction X, and the second light-emitting element rows 118 and the first light-emitting element rows 114 are alternately arranged along the second direction Y. Correspondingly, the first-color light-emitting elements 111 are adjacent to the second-color light-emitting elements 112 and the third-color light-emitting elements 113 respectively, and the adjacent first-color light-emitting elements 111, second-color light-emitting elements 112, and third-color light-emitting elements 113 may constitute one display unit.

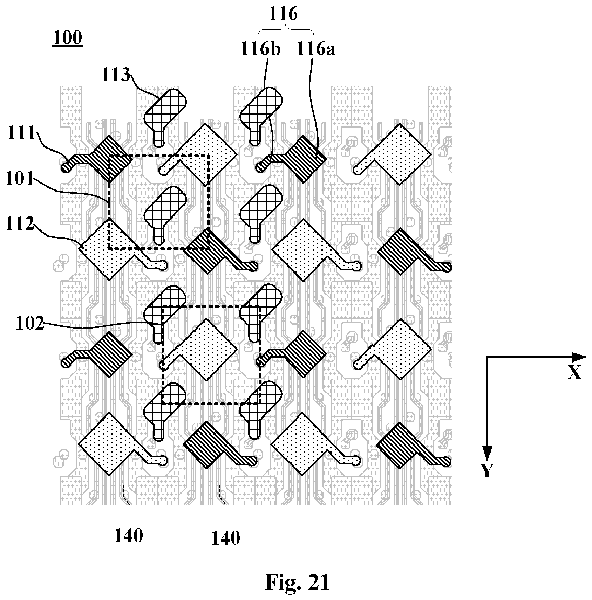

Fig. 21 shows a schematic view of yet another display panel provided in some embodiments of the present application. As shown in Fig. 21, each light-emitting element 110 includes an anode 116, and the anode 116 includes an anode main body portion 116a and an anode connection portion 116b that are connected to each other; the anode main body portion 116a includes a first side and a second side along the second direction Y; and the anode connection portion 116b of each third-color light-emitting element 113 is located at the first side of the anode main body portion 116a thereof. In this embodiment, taking the plane shown in Fig. 21 as an example, the anode main body portion 116a of a third-color light-emitting element 113 includes an upper side and a lower side along the second direction Y, and the anode connection portion 116b of the third-color light-emitting element 113 may be located on the lower side of the anode main body portion 116a thereof. In other embodiments, the anode connection portion 116b of a third-color light-emitting element 113 may also be located on the upper side, left side, or right side of the anode main body portion 116a thereof.

Optionally, referring to Fig. 21, the first-color light-emitting elements 111 and the second-color light-emitting elements 112 are located at intersections of a virtual grid formed by first virtual quadrilaterals 101, for each first virtual quadrilateral, two respective first-color light-emitting elements 111 are located at a first pair of opposite vertices, two respective second-color light-emitting elements 112 are located at a second pair of opposite vertices and a respective third-color light-emitting element 113 is located inside the first virtual quadrilateral 101; and the third-color light-emitting elements 113 are located at intersections of a virtual grid formed by second virtual quadrilaterals 102, for each second virtual quadrilateral 102, four respective third-color light-emitting elements 113 are located at four vertices of the second virtual quadrilateral 102, and a respective first-color light-emitting element 111 or a respective second-color light-emitting element 112 is located inside the second virtual quadrilateral 102. Optionally, the first-color light-emitting elements 111 and the second-color light-emitting elements 112 are red light-emitting elements and blue light-emitting elements respectively; and the third-color light-emitting elements 113 are green light-emitting elements. An anode region of a light-emitting element 110 in Fig. 21 may refer to a light-emitting region of the light-emitting element 110.

In this embodiment, two first-color light-emitting elements 111 and two second-color light-emitting elements 112 constitute a first virtual quadrilateral 101, and a third-color light-emitting element 113 is located inside the first virtual quadrilateral 101; and four third-color light-emitting elements 113 constitute a second virtual quadrilateral 102, and a first-color light-emitting element 111 or a second-color light-emitting element 112 is located inside the second virtual quadrilateral 102. Therefore, the light-emitting elements 110 are evenly distributed in the display panel 100 and the display effect is relatively good.

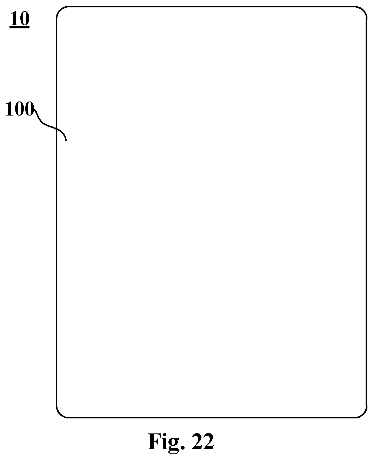

Based on the same inventive concept, the embodiments of the present application further provide a display device which includes any one of the display panels provided in the above-described embodiments. Fig. 22 shows a schematic view of a display device providede in some embodiments of the present application. The display device 10 includes a display panel 100. Therefore, the display device 10 also has the beneficial effects of the display panel 100 in the above-described embodiments, and the same points may be understood with reference to the above description of the display panel 100, and will not be repeated hereinafter.

The display device 10 provided in the embodiments of the present application may be a mobile phone shown in Fig. 22, or any electronic product having a display function, including but not limited to the following categories: a television, a notebook computer, a desktop display, a tablet computer, a digital camera, a smart bracelet, smart glasses, a vehicle display, an industrial control device, a medical display screen, a touch interactive terminal, among others, and the embodiments of the present application are not particularly limited thereto.

It should be noted that, the above description shows only preferred embodiments of the present application and the technical principles used. It will be understood by those skilled in the art that, the present application is not limited to the specific embodiments described herein, and that various changes, readjustments, and substitutions will be obvious to those skilled in the art without departing from the scope of the present application. Therefore, although the present application has been described in more detail by the above embodiments, the present application is not limited to the above embodiments, but may include more other equivalent embodiments without departing from the concept of the present application, and the scope of the present application is determined by the scope of the appended claims.

## Claims

1. A display panel, comprising:
a plurality of light-emitting elements, the plurality of light-emitting elements comprising at least first-color light-emitting elements and second-color light-emitting elements, color emitted by the first-color light-emitting elements is different from color emitted by the second-color light-emitting elements; the plurality of light-emitting elements comprising a plurality of first light-emitting element columns arranged along a first direction and a plurality of first light-emitting element rows arranged along a second direction and, each first light-emitting element row comprising the first-color light-emitting elements and the second-color light-emitting elements alternately arranged along the first direction, each first light-emitting element column comprising the first-color light-emitting elements and the second-color light-emitting elements alternately arranged along the second direction, the first direction not parallel to the second direction; and
a plurality of first pixel circuits, the plurality of first pixel circuits comprising a plurality of first pixel circuit rows arranged along the second direction and a plurality of first pixel circuit columns arranged along the first direction, each first pixel circuit row comprising a plurality of first pixel circuits arranged along the first direction, and each first pixel circuit column comprising a plurality of first pixel circuits arranged along the second direction,
wherein the light-emitting elements that are electrically connected to the first pixel circuits, respectively, in one of the first pixel circuit rows are in a same one of the first light-emitting element rows; and
wherein for adjacent two of the first pixel circuit columns, each first pixel circuit in one of the two first pixel circuit columns is electrically connected to a respective first-color light-emitting element in a first group of first light-emitting element columns among the plurality of first light-emitting element columns, and each first pixel circuit in another one of the two first pixel circuit columns is electrically connected to a respective second-color light-emitting element in a second group of first light-emitting element columns among the plurality of the first light-emitting element columns.

2. The display panel according to claim 1, wherein
the plurality of first light-emitting element columns comprises at least a P-th first light-emitting element column, a (P+1)-th first light-emitting element column, and a (P+2)-th first light-emitting element column, which are adjacent first light-emitting element column sequentially arranged along the first direction, wherein P ≥ 1;
the plurality of first pixel circuit columns comprises at least a Q-th first pixel circuit column, a (Q+1)-th first pixel circuit column, and a (Q+2)-th first pixel circuit column, which are adjacent first light-emitting element column sequentially arranged along the first direction, wherein Q ≥ 1;
each first pixel circuit in the (Q+1)-th first pixel circuit column is electrically connected to a respective second-color light-emitting element in a group of first light-emitting element columns comprising the (P+1)-th first light-emitting element column and the P-th first light-emitting element column; and
each first pixel circuit in the (Q+2)-th first pixel circuit column is electrically connected to a respective first-color light-emitting element in a group of first light-emitting element columns comprising the (P+2)-th first light-emitting element column and the (P+1)-th first light-emitting element column.

3. The display panel according to claim 2, wherein a first pixel circuit ranked i-th in sequential arrangement of the first pixel circuits in the (Q+1)-th first pixel circuit column is electrically connected to a light-emitting element ranked i-th in sequential arrangement of the light-emitting elements in the (P+1)-th first light-emitting element column, and a first pixel circuit ranked (i+1)-th in sequential arrangement of the first pixel circuits in the (Q+1)-th first pixel circuit column is electrically connected to a light-emitting element ranked (i+1)-th in sequential arrangement of the light-emitting elements in the P-th first light-emitting element column; and
a first pixel circuit ranked i-th in sequential arrangement of the first pixel circuits in the (Q+2)-th first pixel circuit column is electrically connected to a light-emitting element ranked i-th in sequential arrangement of the light-emitting elements in the (P+2)-th first light-emitting element column, and a first pixel circuit ranked (i+1)-th in sequential arrangement of the first pixel circuits in the (Q+2)-th first pixel circuit column is electrically connected to a light-emitting element ranked (i+1)-th in sequential arrangement of the light-emitting elements in the (P+1)-th first light-emitting element column.

4. The display panel according to claim 1, wherein
the plurality of first light-emitting element columns comprises at least a (Pa-1)-th first light-emitting element column and a Pa-th first light-emitting element column that are adjacent to each other, wherein Pa ≥ 2;
the plurality of first pixel circuit columns comprises Qa first pixel circuit columns arranged in an order of a first first pixel circuit column through a Qa-th first pixel circuit column, wherein Qa ≥ 3;
along the first direction, the first-color light-emitting elements that are electrically connected to the first pixel circuits, respectively, in the first first pixel circuit column are in a same one of the first light-emitting element columns, and the first pixel circuits in the Qa-th first pixel circuit column are electrically connected to the first-color light-emitting elements, respectively, in a group of first light-emitting element columns comprising the Pa-th first light-emitting element column and the (Pa-1)-th first light-emitting element column.

5. The display panel according to claim 4, wherein the second-color light-emitting elements in the Pa-th first light-emitting element column are electrically connected to the first pixel circuits, respectively, in the (Qa-1)-th first pixel circuit column.

6. The display panel according to claim 4, wherein
the first pixel circuit ranked i-th in sequential arrangement of the first pixel circuits in the (Qa-1)-th first pixel circuit column is electrically connected to the light-emitting element ranked i-th in sequential arrangement of the light-emitting elements in the (Pa-1)-th first light-emitting element column, and
the first pixel circuit ranked (i+1)-th in sequential arrangement of the first pixel circuits in the (Qa-1)-th first pixel circuit column is electrically connected to the light-emitting element ranked (i+1)-th in sequential arrangement of the light-emitting elements in the Pa-th first light-emitting element column and the light-emitting element ranked (i+1)-th in sequential arrangement of the light-emitting elements in the (Pa-2)-th first light-emitting element column.

7. The display panel according to claim 1, wherein the plurality of first light-emitting element columns comprises at least a (Pa-1)-th first light-emitting element column and a Pa-th first light-emitting element column that are adjacent to each other, wherein Pa ≥ 2;
the plurality of first pixel circuit columns comprises Qa first pixel circuit columns arranged in an order of a first first pixel circuit column through a Qa-th first pixel circuit column, wherein Qa ≥ 3; and
along the first direction, the first-color light-emitting elements that are electrically connected to the first pixel circuits, respectively, in the first first pixel circuit column are in a same one of the first light-emitting element columns, and the first pixel circuits in the Qa-th first pixel circuit column are electrically connected to the second-color light-emitting elements, respectively, in a group of first light-emitting element columns comprising the Pa-th first light-emitting element column and the (Pa-1)-th first light-emitting element column.

8. The display panel according to claim 7, wherein the first-color light-emitting elements in the Pa-th first light-emitting element column are electrically connected to the first pixel circuits, respectively, in the (Qa-1)-th first pixel circuit column.

9. The display panel according to claim 1, wherein
the plurality of first light-emitting element columns comprise at least a P-th first light-emitting element column, a (P+1)-th first light-emitting element column, a (P+2)-th first light-emitting element column, and a (P+3)-th first light-emitting element column, which are adjacent first light-emitting element column sequentially arranged along the first direction, wherein P ≥ 1;
the plurality of first pixel circuit columns comprise at least a Q-th first pixel circuit column, a (Q+1)-th first pixel circuit column, a (Q+2)-th first pixel circuit column, and a (Q+3)-th first pixel circuit column, which are adjacent first light-emitting element column sequentially along the first direction, wherein Q ≥ 1;
each first pixel circuit in the (Q+1)-th first pixel circuit column is electrically connected to a respective first-color light-emitting element in a group of first light-emitting element columns comprising the (P+1)-th first light-emitting element column and the (P+2)-th first light-emitting element column; and
each first pixel circuit in the (Q+2)-th first pixel circuit column is electrically connected to a respective second-color light-emitting element in a group of first light-emitting element columns comprising the (P+2)-th first light-emitting element column and the (P+3)-th first light-emitting element column.

10. The display panel according to claim 9, wherein
a first pixel circuit ranked i-th in sequential arrangement of the first pixel circuits in the (Q+1)-th first pixel circuit column is electrically connected to an light-emitting element ranked i-th in sequential arrangement of the light-emitting elements in the (P+1)-th first light-emitting element column, and a first pixel circuit ranked (i+1)-th in sequential arrangement of the first pixel circuits in the (Q+1)-th first pixel circuit column is electrically connected to a light-emitting element ranked (i+1)-th in sequential arrangement of the light-emitting elements in the (P+2)-th first light-emitting element column; and
a first pixel circuit ranked i-th in sequential arrangement of the first pixel circuits in the (Q+2)-th first pixel circuit column is electrically connected to a light-emitting element ranked i-th in sequential arrangement of the light-emitting elements in the (P+2)-th first light-emitting element column, and a first pixel circuit ranked (i+1)-th in sequential arrangement of the first pixel circuits in the (Q+2)-th first pixel circuit column is electrically connected to a light-emitting element ranked (i+1)-th in sequential arrangement of the light-emitting elements in the (P+3)-th first light-emitting element column.

11. The display panel according to claim 1, wherein the plurality of first light-emitting element columns comprises at least a Pb-th first light-emitting element column and a (Pb+1)-th first light-emitting element column that are adjacent to each other, wherein Pb ≥ 1;
the plurality of first pixel circuit columns comprises Qa first pixel circuit columns arranged in an order of a first first pixel circuit column through a Qa-th first pixel circuit column, wherein Qa ≥ 3; and
along the first direction, the first pixel circuits in the first first pixel circuit column are electrically connected to the second-color light-emitting elements, respectively, in a group of first light-emitting element columns comprising the Pb-th first light-emitting element column and the (Pb+1)-th first light-emitting element column, and the second-color light-emitting elements that are electrically connected to the first pixel circuits, respectively, in the Qa-th first pixel circuit column are in a same one of the first light-emitting element columns.

12. The display panel according to claim 11, wherein the first-color light-emitting elements in the Pb-th first light-emitting element column are electrically connected to the first pixel circuits, respectively, in a second first pixel circuit column.

13. The display panel according to claim 11, wherein the first pixel circuit ranked i-th in sequential arrangement of the first pixel circuits in the second first pixel circuit column is electrically connected to the light-emitting element ranked i-th in sequential arrangement of the light-emitting elements in the (Pb+1)-th first light-emitting element column, and the first pixel circuit ranked (i+1)-th in sequential arrangement of the first pixel circuits in the second first pixel circuit column is electrically connected to the light-emitting element ranked (i+1)-th in sequential arrangement of the light-emitting elements in the Pb-th first light-emitting element column and the light-emitting element ranked (i+1)-th in sequential arrangement of the light-emitting elements in the (Pb+2)-th first light-emitting element column.

14. The display panel according to claim 1, wherein the plurality of first light-emitting element columns comprises at least a Pb-th first light-emitting element column and a (Pb+1)-th first light-emitting element column that are adjacent to each other, wherein Pb ≥ 1;
the plurality of first pixel circuit columns comprises Qa first pixel circuit columns arranged in an order of a first first pixel circuit column through a Qa-th first pixel circuit column, wherein Qa ≥ 3; and
along the first direction, the first pixel circuits in the first first pixel circuit column are electrically connected to the first-color light-emitting elements, respectively, in the Pb-th first light-emitting element column, and the second-color light-emitting elements that are electrically connected to the first pixel circuits, respectively, in the Qa-th first pixel circuit column are in a same one of the first light-emitting element columns.

15. The display panel according to claim 14, wherein the second-color light-emitting elements in the Pb-th first light-emitting element column are electrically connected to the first pixel circuits, respectively, in the second first pixel circuit column.

16. The display panel according to claim 2, wherein
the display panel further comprises a plurality of first data lines arranged along the first direction, each first data line extends along the second direction, and the first pixel circuits connected to one of the first data lines are in a same one of the first pixel circuit columns;
each light-emitting element comprises an anode, and the anode comprises an anode main body portion and an anode connection portion that are connected to each other;
for each second-color light-emitting element in the (P+1)-th first light-emitting element column, the anode connection portion is located at a side of the anode main body portion away from the first data line electrically connected to the (Q+1)-th first pixel circuit column, and
for each second-color light-emitting element in the P-th first light-emitting element column, the anode connection portion is located at a side of the anode main body portion close to the first data line electrically connected to the (Q+1)-th first pixel circuit column;
for each first-color light-emitting element in the (P+1)-th first light-emitting element column, the anode connection portion is located at a side of the anode main body portion close to the first data line electrically connected to the (Q+2)-th first pixel circuit column, and for each first-color light-emitting element in the (P+2)-th first light-emitting element column, the anode connection portion is located at a side of the anode main body portion away from the first data line electrically connected to the (Q+2)-th first pixel circuit column.

17. The display panel according to claim 1, wherein each light-emitting element comprises an anode, and the anode comprises an anode main body portion and an anode connection portion that are connected to each other;
for each first light-emitting element row, the anode connection portion of each light-emitting element in the first light-emitting element row is located at a same side of the anode main body portion of the light-emitting element.

18. The display panel according to claim 9, wherein
the display panel further comprises a plurality of first data lines arranged along the first direction, each first data line extends along the second direction, and the first pixel circuits connected to one of the first data lines are in a same one of the first pixel circuit columns;
each light-emitting element comprises an anode, and the anode comprises an anode main body portion and an anode connection portion that are connected to each other;
the display panel comprises a plurality of bridge portions;
for each second-color light-emitting element in the (P+2)-th first light-emitting element column, the anode connection portion is located at a side of the anode main body portion away from the first data line electrically connected to the (Q+2)-th first pixel circuit column, and for each second-color light-emitting element in the (P+3)-th first light-emitting element column, the anode connection portion is electrically connected to a respective first pixel circuit in the (Q+2)-th first pixel circuit column through a respective one of the bridge portions; and
for each first-color light-emitting element in the (P+1)-th first light-emitting element column, the anode connection portion is located at a side of the anode main body portion away from the first data line electrically connected to the (Q+1)-th first pixel circuit column, and for each first-color light-emitting element in the (P+2)-th first light-emitting element column, the anode connection portion is electrically connected to a respective first pixel circuit in the (Q+1)-th first pixel circuit column through a respective one of the bridge portions.

19. The display panel according to claim 18, wherein the display panel comprises a substrate, and a film layer in which the bridge portions is located is between a film layer of the anode and a film layer of the substrate.

20. The display panel according to claim 18, wherein
each first pixel circuit comprises at least one transistor, each transistor of the at least one transistor comprising a first active layer;
each first pixel circuit further comprises a storage capacitor, the storage capacitor comprising a first plate and a second plate arranged opposite to each other, and the second plate is located at a side of the first plate away from the first active layer;
the display panel further comprises a first semiconductor layer, a first metal layer, a second metal layer, and a third metal layer;
the first active layer is located on the first semiconductor layer, the first plate is located on the first metal layer, the second plate is located on the second metal layer, and the third metal layer is located at a side of the second metal layer away from the first active layer;
each bridge portion is located in at least one of the first metal layer, the second metal layer, or the third metal layer.

21. The display panel according to claim 18, wherein
each first pixel circuit comprises at least one transistor, each transistor of the at least one transistor comprising a first active layer;
each first pixel circuit further comprises a storage capacitor, the storage capacitor comprising a first plate and a second plate arranged opposite to each other, and the second plate is located at a side of the first plate away from the first active layer;
the display panel further comprises a first semiconductor layer, a first metal layer, a second metal layer, a third metal layer, and a fourth metal layer; the first active layer is located on the first semiconductor layer, the first plate is located on the first metal layer, the second plate is located on the second metal layer, the third metal layer is located at one side of the second metal layer away from the first active layer, and the fourth metal layer is located at one side of the third metal layer away from the first active layer;
each bridge portion is located in at least one of the first metal layer, the second metal layer, the third metal layer, or the fourth metal layer.

22. The display panel according to claim 1, further comprising:
a plurality of first data lines arranged along the first direction, each first data line extending along the second direction, and the first pixel circuits connected to one of the first data lines being in a same one of the first pixel circuit columns;
a plurality of second data lines arranged along the first direction, each second data lines extending along the second direction; and
a plurality of second pixel circuit columns arranged along the first direction, each second pixel circuit column comprising a plurality of second pixel circuits arranged along the second direction, the second pixel circuits in each second pixel circuit column being electrically connected to a same one of the second data lines,
wherein the plurality of light-emitting elements comprise the first-color light-emitting elements, the second-color light-emitting elements, and third-color light-emitting elements, and each second pixel circuit is electrically connected to a respective one of the third-color light-emitting elements.

23. The display panel according to claim 22, wherein the first data lines and the second data lines are alternately arranged along the first direction.

24. The display panel according to claim 22, further comprising second light-emitting element rows, wherein the second light-emitting element rows and the first light-emitting element rows are alternately arranged along the second direction; and
each second light-emitting element row comprises a plurality of third-color light-emitting elements arranged along the first direction.

25. The display panel according to claim 22, wherein
each light-emitting element comprises an anode, and the anode comprises an anode main body portion and an anode connection portion that are connected to each other, the anode main body portion comprising a first side and a second side along the second direction; and
the anode connection portion of each third-color light-emitting element is located at the first side of the anode main body portion thereof.

26. The display panel according to claim 22, wherein
the first-color light-emitting elements and the second-color light-emitting elements are located at intersections of a virtual grid formed by first virtual quadrilaterals,
for each first virtual quadrilateral, two respective first-color light-emitting elements are located at a first pair of opposite vertices, and two respective second-color light-emitting elements are located at a second pair of opposite vertices, and a respective third-color light-emitting element of the third-color light-emitting elements is located inside the first virtual quadrilateral;
the third-color light-emitting elements are located at intersections of a virtual grid formed by second virtual quadrilaterals,
for each second virtual quadrilateral, four respective third-color light-emitting elements are located at four vertices of the second virtual quadrilateral; and a respective first-color light-emitting element or a respective second-color light-emitting element is located inside the second virtual quadrilateral.

27. The display panel according to claim 22, wherein the first-color light-emitting elements and the second-color light-emitting elements are red light-emitting elements and blue light-emitting elements, respectively; and
the third-color light-emitting elements are green light-emitting elements.

28. A display device, comprising the display panel according to any one of claims 1 to 27.
